# EUROPEAN PATENT SPECIFICATION

(11) **EP 3 467 551 B1**
(45) Date of publication and mention of the grant of the patent: **26.05.2021**
(21) Application number: 17806834.2
(22) Date of filing: 02.06.2017
(51) Int. Cl.: G03F 7/004, B42D 25/47, G03F 7/34, G02B 3/00, B42D 25/328, B41M 3/14, B32B 37/14, G02B 5/18, B42D 25/36, B42D 25/41, G03H 1/00

(54) **METHOD FOR MANUFACTURING DISPLAY BODY**
VERFAHREN ZUR HERSTELLUNG EINES ANZEIGEKÖRPERS
PROCÉDÉ DE FABRICATION D'UN CORPS D'AFFICHAGE

(30) Priority: 02.06.2016 JP 2016111231
(43) Date of publication of application: 10.04.2019
(73) Proprietor: Toppan Printing Co., Ltd., Tokyo 110-0016 (JP)
(72) Inventor: KAIZUKA, Tomoyoshi, Tokyo 110-0016 (JP)
(74) Representative: Hoffmann Eitle
(86) International application number: PCT/JP2017/020630
(87) International publication number: WO 2017/209284

(56) References cited:
- WO-A2-2015/148878
- JP-A- 2003 337 208
- JP-A- 2004 045 586
- JP-A- 2004 271 798
- JP-A- 2005 037 693
- JP-A- 2005 037 694
- JP-A- 2012 512 059
- US-A1- 2005 153 107
- US-A1- 2008 036 196
- US-A1- 2011 127 762

## Description

### [Technical Field]

The present invention relates to a method of producing a display body containing a micro-relief structure.

### [Background Art]

Display bodies that are difficult to forge containing a hologram and the like are imparted to valuable papers, such as banknotes and gift certificates, and articles containing an authentication medium, such as passports, to prevent forgery (e.g., refer to PTL 1). Such a display body is used for visual determination of authenticity of an article and the authenticity of the article is determined on the basis of the authenticity of the display body.

In such a display body, differentiation from a structure similar to the display body and resistance to forgery of the display body are improved by a micro-relief structure contained in the display body, a pattern in a reflective layer contained in the hologram, and the like.

### [Citation List]

### [Patent Literature]

[PTL 1] JP 2003-255115 A

US 2011/0127762 A1 discloses a method for producing a security element, comprising the steps: a) supplying a first security-element partial element, having a first substrate, a first functional layer with first functional areas and first gaps; b) supplying a second security-element partial element, having: a second substrate, a second functional layer on the second substrate; c) forming an adhesive layer from a radiation-conditionable adhesive on the first security-element partial element or the second security-element partial element; d) assembling the first and the second security-element partial elements to a composite in such a way that the adhesive layer and the second functional layer of the second security-element partial element face each other; e) irradiating the adhesive layer after the assembling of the composite through the first security-element partial element, wherein the first functional layer of the first security-element partial element acts as an irradiation mask, so that in the adhesive layer there are formed non-irradiated areas congruent with the first functional areas, and areas conditioned by irradiation that are congruent with the first gaps; f) bonding the first and the second security-element partial elements, whereby the bonding is caused by the conditioned areas; and g) detaching the second substrate from the bonded composite, wherein the second functional layer, so as to form second functional areas, adheres to the conditioned areas of the adhesive layer but does not adhere to the non-irradiated areas of the adhesive layer and is detached together with the second carrier substrate.

### [Summary of the Invention]

### [Technical Problem]

A micro-relief structure contained in the display body is generally patterned by thermal transfer using a heated roll, and thus materials to form the display body are required to have heat resistance to the extent of not being damaged by thermal transfer. A reflective layer is generally etched using an acid or alkali corrosive to the materials to form the reflective layer, and thus the materials to form the display body are required to have resistance to acid or alkali. As just described, the materials to form the display body are under various restrictions and thus it is sometimes difficult to select the forming materials.

Such issues are not limited to a display body used to prevent forgery of articles and are common with display bodies used to decorate articles, display bodies which are in themselves objects for observation, and the like.

It is an object of the present invention to provide a method of producing a display body, that allows, in patterning of a display body, relaxation of the restrictions on chemical resistance and heat resistance of materials to form the display body.

### [Solution to Problem]

A method of producing a display body comprising: providing a patterning target layer and a resin layer in this order on a surface of a substrate such that the layers are in contact with each other, wherein the resin layer contains a resin curable by irradiation and the patterning target layer contains a thermoplastic resin and a resin curable by irradiation;irradiating the resin layer which is in contact with the patterning target layer with radiation to form a plurality of cured portions by partial curing of the resin layer so as to establish higher adhesion strength between the cured portions and the patterning target layer than adhesion strength between the surface and the patterning target layer and to establish lower adhesion strength between the uncured portion in the resin layer and the patterning target layer than the adhesion strength between the surface and the patterning target layer, and separating the resin layer from the patterning target layer, thereby removing areas of the patterning target layer, which overlap the cured portions in plan view facing the surface, from the substrate together with the resin layer.

According to the above configuration, the cured portions are formed in the resin layer by irradiating the resin layer, and using a difference between the adhesion strength between the cured portions in the resin layer and the patterning target layer and the adhesion strength between the uncured portion in the resin layer and the patterning target layer, the patterning target layer is patterned in a predetermined shape. That is, in the above configuration, patterning of the patterning target layer does not require heating of the elements constituting the display body or immersion of the elements constituting the display body in acid or alkali, and it is thus possible to relax the restrictions on chemical resistance and heat resistance of the materials to form the display body.

### [Brief Description of Drawings]

Fig. 1 is a process diagram illustrating a procedure of forming a resin layer in a first embodiment embodying a method of producing a display body.
Fig. 2 is a process diagram illustrating a procedure of forming a patterning target layer on a substrate in the method of producing a display body.
Fig. 3 is a process diagram illustrating a procedure of contacting the resin layer with the patterning target layer in the method of producing a display body.
Fig. 4 is a process diagram illustrating a procedure of irradiating the resin layer in the method of producing a display body.
Fig. 5 is another process diagram illustrating the procedure of irradiating the resin layer in the method of producing a display body.
Fig. 6 is a perspective view illustrating the resin layer after irradiation.
Fig. 7 is a process diagram illustrating a procedure of separating the resin layer from the patterning target layer in the method of producing a display body.
Fig. 8 is a process diagram illustrating a procedure of forming a bonding layer on the substrate in a method of producing a display label.
Fig. 9 is a process diagram illustrating a procedure of forming a release layer on the bonding layer in the method of producing a display label.
Fig. 10 is a cross-sectional view illustrating a cross-sectional structure of the display body attached to a base material together with a cross-sectional structure of the base material.
Fig. 11 is a plan view illustrating a planar structure of the display body attached to the base material together with a planar structure of the base material.
Fig. 12 is a cross-sectional view illustrating a cross-sectional structure of a display body attached to a base material in another example together with a cross-sectional structure of the base material.
Fig. 13 is a cross-sectional view illustrating a cross-sectional structure of a display body attached to a base material in another example together with a cross-sectional structure of the base material.
Fig. 14 is a process diagram illustrating a procedure of irradiating the resin layer in a modification.
Fig. 15 is a process diagram illustrating a procedure of separating the resin layer from the patterning target layer in another modification.
Fig. 16 is a process diagram illustrating a procedure of irradiating the resin layer in another modification.
Fig. 17 is a process diagram illustrating a procedure of separating the resin layer from the patterning target layer in another modification.
Fig. 18 is a process diagram illustrating a procedure of forming a precursor layer in a second embodiment embodying a method of producing a display body.
Fig. 19 is a process diagram illustrating a procedure of forming a relief structure layer in the method of producing a display body
Fig. 20 is a process diagram illustrating a procedure of forming a reflective layer in the method of producing a display body.
Fig. 21 is a process diagram illustrating a procedure of irradiating the resin layer in the method of producing a display body.
Fig. 22 is a process diagram illustrating a procedure of separating the resin layer from the reflective layer in the method of producing a display body.
Fig. 23 is a process diagram illustrating a procedure of forming a patterning target layer in a third embodiment embodying a method of producing a display body.
Fig. 24 is a process diagram illustrating a procedure of irradiating the resin layer in the method of producing a display body.
Fig. 25 is a process diagram illustrating a procedure of separating the resin layer from the patterning target layer in the method of producing a display body.
Fig. 26 is a process diagram illustrating a procedure of forming a lens array layer in a fourth embodiment embodying a method of producing a display body.
Fig. 27 is a plan view illustrating a planar structure of the lens array layer.
Fig. 28 is a process diagram illustrating a procedure of forming a resin layer in the method of producing a display body.
Fig. 29 is a process diagram illustrating a procedure of irradiating the resin layer in the method of producing a display body.
Fig. 30 is another process diagram illustrating the procedure of irradiating the resin layer in the method of producing a display body.
Fig. 31 is a process diagram illustrating a procedure of separating the resin layer from the patterning target layer in the method of producing a display body.
Fig. 32 is a process diagram illustrating a procedure of irradiating the resin layer in a modification.
Fig. 33 is a plan view illustrating a planar structure of the resin layer after irradiation in another modification.
Fig. 34 is a plan view illustrating a planar structure of the lens array layer in another modification.

### [Description of Embodiments]

### [First Embodiment]

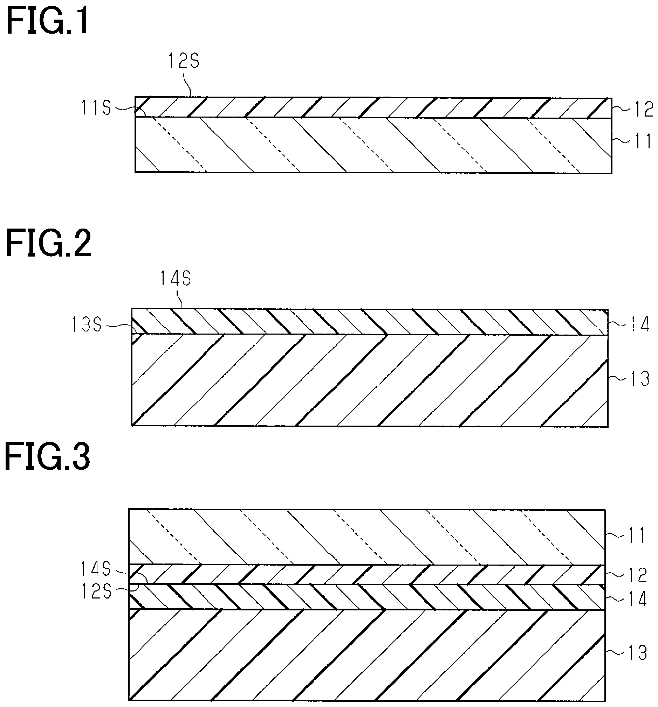

With reference to Figs. 1 to 13, a description is given to a first embodiment embodying a method of producing a display body, a display intermediate, and a display body. The display intermediate and the display body do not form part of the invention as defined by the claims. In the description below, a method of producing a display body, a display label, and materials to form the display body are described in order.

### [Method of Producing Display Body]

In a method of producing a display body, a patterning target layer formed on a surface of a substrate is in contact with a resin layer containing a resin curable by irradiation, and the resin layer in contact with the patterning target layer is irradiated to partially cure the resin layer and thus to form a plurality of cured portions. That is, in the method of producing a display body, a patterning target layer and a resin layer are placed on a surface of a substrate to be in contact with each other in order from the surface of the substrate.

The method of producing a display body thus includes establishing higher adhesion strength between the cured portions and the patterning target layer than adhesion strength between the surface and the patterning target layer and establishing lower adhesion strength between the uncured portion in the resin layer and the patterning target layer than the adhesion strength between the surface and the patterning target layer.

The method of producing a display body also includes separating areas overlapping the cured portions in the patterning target layer in plan view facing the surface from the substrate together with the resin layer by separating the resin layer from the patterning target layer.

In the patterning target layer, an area separated from the substrate together with the resin layer is a first area and the area other than the first area is a second area. By separating the areas overlapping the cured portions in the patterning target layer from the substrate together with the resin layer, a first laminate containing the resin layer and the first area and a second laminate containing the substrate and the second area are formed, and the display body is a display body produced from either one of the first laminate and the second laminate.

That is, in the method of producing a display body, when the resin layer is separated from the patterning target layer, the first laminate containing the resin layer and the first area and the second laminate containing the substrate and the second area are formed and the display body is produced from either one of the first laminate and the second laminate.

With reference to Figs. 1 to 7, the method of producing a display body is described below in more detail. As illustrated in Fig. 1, a first substrate 11 transparent to radiation is provided, and a resin layer 12 is formed on a front surface 11S, which is one surface of the first substrate 11. The radiation may be any of, for example, ultraviolet light, an electron beam, and a laser beam. Materials to form the resin layer 12 contain a resin curable by irradiation with such radiation. In the resin layer 12, a surface on a side opposite to that in contact with the first substrate 11 is a front surface 12S. The amount of radiation for irradiation of the resin layer 12 may be 30 mJ/cm² or more and 2 J/cm² or less. The resin layer 12 may have a thickness of 0.1 µm or more and 5 µm or less.

As illustrated in Fig. 2, a second substrate 13 having a front surface 13S is prepared, and a patterning target layer 14 containing a resin is formed on the front surface 13S of the second substrate 13. In the patterning target layer 14, a surface on a side opposite to that in contact with the second substrate 13 is a front surface 14S.

As illustrated in Fig. 3, the resin layer 12 and the patterning target layer 14 are in contact with each other to have the front surface 12S of the resin layer 12 facing the front surface 14S of the patterning target layer 14. In this situation, while the resin layer 12 is in contact with the patterning target layer 14, a force pressing the layers in a stacking direction is preferably applied to at least one of the resin layer 12 and the patterning target layer 14. In other words, the resin layer 12 and the patterning target layer 14 arc preferably press-bonded with a predetermined force.

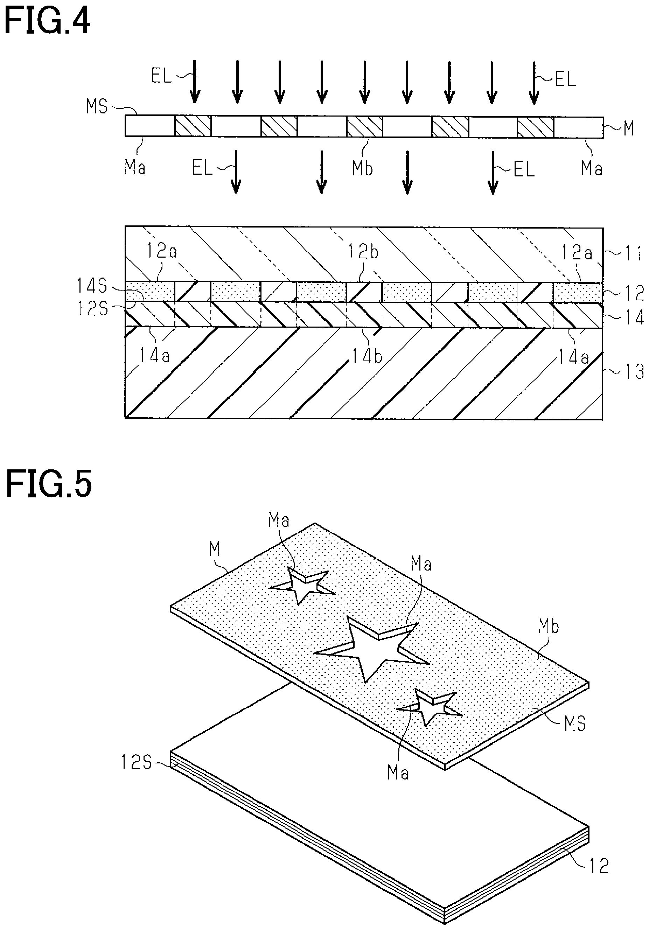

As illustrated in Fig. 4, the resin layer 12 in contact with the patterning target layer 14 is irradiated with radiation EL. Here, a mask M is positioned facing the resin layer 12 with the first substrate 11 therebetween, and the resin layer 12 is irradiated with the radiation EL via the mask M.

The mask M includes transmitting areas Ma that transmit the radiation EL, and the areas in the mask M other than the transmitting areas Ma are blocking areas Mb that block the radiation EL. In the mask M, a surface facing away from the first substrate 11 is a front surface MS.

Since the resin layer 12 is irradiated with the radiation EL via the mask M, only the portions of the radiation EL passing through the transmitting areas Ma reach the resin layer 12. The irradiation of the resin layer 12 with the radiation EL thus cures part of the resin layer 12 and a plurality of cured portions 12a are formed in the resin layer 12.

In the resin layer 12 after irradiation, the areas other than the cured portions 12a are uncured portions 12b. In other words, in the resin layer 12 after irradiation, the uncured portions 12b fill gaps between the plurality of cured portions 12a.

In a direction of in which the resin layer 12 and the patterning target layer 14 are stacked, areas of the patterning target layer 14 which overlap the cured portions 12a are first areas 14a and areas which overlap the uncured portions 12b arc second areas 14b.

As illustrated in Fig. 5, in a plan view facing the front surface 12S of the resin layer 12, the mask M includes the three transmitting areas Ma and each transmitting area Ma has an outer periphery in a star shape. As described above, the resin layer 12 is irradiated with the radiation EL via the mask M. The shape of the outer periphery in each transmitting area Ma is not limited to a star shape and may be another shape, such as a linear shape and a circular shape. The number of transmitting areas Ma in the mask M may be a number other than three, and may be two or less or may be four or more.

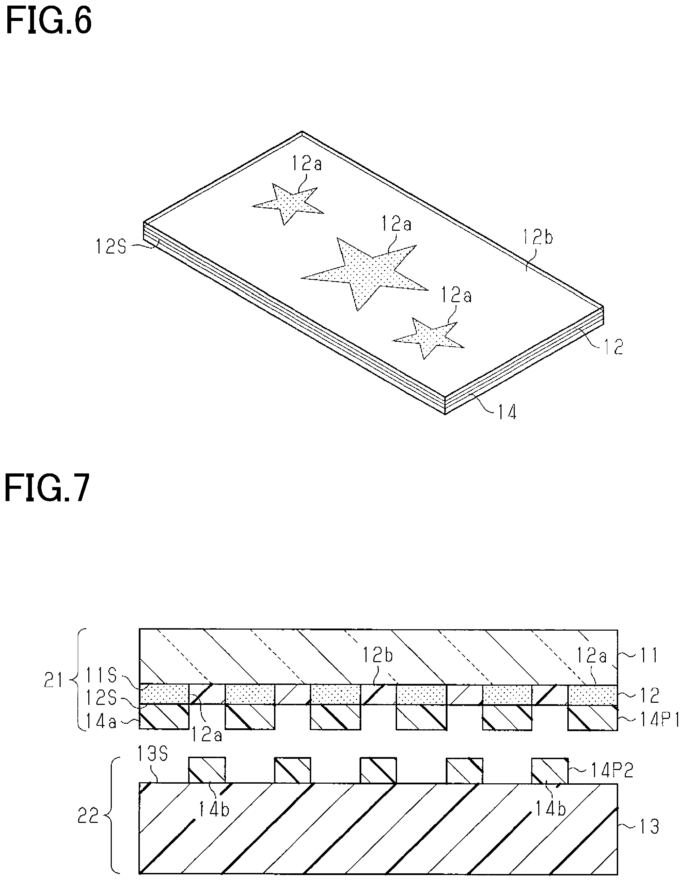

As illustrated in Fig. 6, the three cured portions 12a are thus formed in the resin layer 12 after irradiation, and in a plan view facing the front surface 12S, each cured portion 12a has a star shape. Each cured portion 12a is cured by irradiation with the radiation EL to be adhered to the first area 14a overlapping each cured portion 12a in the patterning target layer 14 in the stacking direction of the resin layer 12 and the patterning target layer 14. As described above, when the transmitting areas Ma have an outer periphery in a shape other than a star shape and the mask M has the transmitting areas Ma of other than three, the resin layer 12 has the cured portions 12a corresponding to the shape of the outer periphery of the transmitting areas Ma of the same number as the transmitting areas Ma.

In the laminate containing the resin layer 12 after irradiation, adhesion strength between the cured portions 12a and the patterning target layer 14 is higher than adhesion strength between the front surface 13S of the second substrate 13 and the patterning target layer 14 and adhesion strength between the uncured portions 12b and the patterning target layer 14 is lower than the adhesion strength between the front surface 13S of the second substrate 13 and the patterning target layer 14.

That is, as respective materials to form the first substrate 11, the resin layer 12, the second substrate 13, and the patterning target layer 14, materials may be selected to establish the relationship of the adhesion strength described above for the resin layer 12, the second substrate 13, and the patterning target layer 14 after irradiating the resin layer 12 with the radiation EL.

The materials to form the mask M may be, for example, any of plastics, glass, metal, and the like. The mask M may have a plurality of layers, and materials to form each layer may be any of plastics, glass, metal, and the like described above. In the mask M, the transmitting areas Ma are openings penetrating the mask M in the thickness direction of the mask M or may be areas made of materials transparent to the radiation EL.

In plan view facing the front surface MS, an area S of the transmitting areas Ma is preferably 5 µm² or more, and an interval K between the transmitting areas Ma is preferably 5 µm or more. When the resin layer 12 is irradiated with the radiation EL, in the plan view facing the front surface MS of the mask M, the areas approximately 1 µm to 3 µm outside the outer periphery of the transmitting areas Ma in the resin layer 12 are sometimes slightly cured by the radiation EL leaked from the transmitting areas Ma.

Accordingly, when the interval K is 5 µm or more, linkage of irradiated areas of the resin layer 12, irradiated with the radiation EL, to each other, and adhesion of areas connecting the irradiated areas to the patterning target layer 14 together with the irradiated areas are suppressed. This suppresses unintended areas in the patterning target layer 14 from being released from the second substrate 13 together with the resin layer 12.

As illustrated in Fig. 7, by separating the resin layer 12 from the patterning target layer 14, in a plan view facing the front surface 13S of the second substrate 13, the first areas 14a overlapping the cured portions 12a in the patterning target layer 14 are separated from the front surface 13S of the second substrate 13 together with the resin layer 12. The first areas 14a in the patterning target layer 14 are thus placed on the front surface 12S of the resin layer 12 while the second areas 14b remain placed on the front surface 13S of the second substrate 13.

Of the two laminates thus formed, the laminate which includes the first areas 14a of the patterning target layer 14, that is, the laminate which includes the first substrate 11, the resin layer 12, and the first areas 14a, is a first laminate 21. The plurality of first areas 14a form a first pattern layer 14P1, and each first area 14a is a first pattern element.

The first laminate 21 is an example of a display intermediate. That is, the first laminate 21 includes the first substrate 11 having the front surface 11S, and the resin layer 12 facing the front surface 11S of the first substrate 11, in other words, placed on the front surface 11S of the first substrate 11, and containing a resin curable by irradiation with the radiation EL. The resin layer 12 includes the plurality of cured portions 12a and the uncured portions 12b filling gaps between the plurality of cured portions 12a. The first laminate 21 further includes the first pattern layer 14P1 which is in contact with the surface of the resin layer 12 which faces away from the first substrate 11. The first pattern layer 14P1 includes the plurality of first areas 14a. In a plan view facing the front surface 11S of the first substrate 11, each first area 14a overlaps a cured portion 12a different from a cured portion 12a overlapped by another first area 14a.

Meanwhile, the laminate which includes the second areas 14b of the patterning target layer 14, that is, the laminate which includes the second substrate 13 and the second areas 14b is a second laminate 22. The second areas 14b form a second pattern layer 14P2. The second pattern layer 14P2 may be configured from a plurality of second areas 14b, and in this case, each second area is a second pattern element. Both the first laminate 21 and the second laminate 22 are capable of functioning as a display body.

A method of producing a display body may include processes other than the process described above in production of a display body which includes the first laminate 21 or a display body which includes the second laminate 22.

The cured portions 12a are formed in the resin layer 12 by irradiating the resin layer 12 with the radiation EL, and the patterning target layer 14 is patterned in a predetermined shape, using a difference between the adhesion strength between the cured portions 12a and the patterning target layer 14 and the adhesion strength between the uncured portions 12b and the patterning target layer 14. That is, the method of producing a display body described above does not require thermal transfer of the elements constituting the display body or immersion of the elements constituting the display body in acid or alkali for patterning of the patterning target layer 14. Accordingly, it is possible to relax the restrictions on chemical resistance and heat resistance of the materials to form the display body.

In particular, when a pattern layer having a predetermined pattern is formed from a patterning target layer containing a resin, part of the patterning target layer is generally transferred to a transferred object by thermal transfer using a heated roll. Accordingly, the patterning target layer is required to have resistance to thermal transfer. In this regard, the method of producing a display body described above does not require thermal transfer for patterning of the patterning target layer 14, which allows relaxation of the restrictions on heat resistance.

### [Display label]

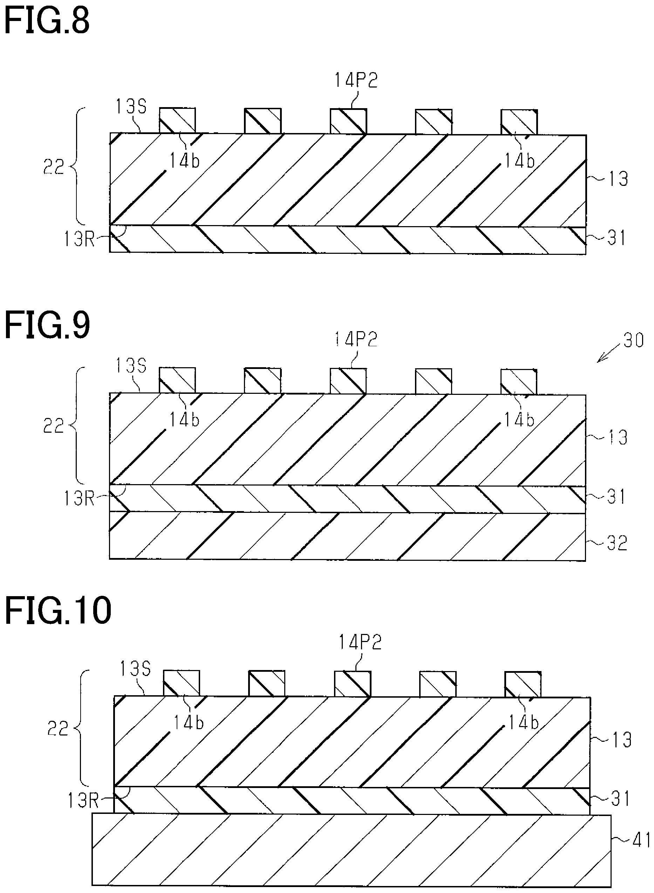

With reference to Figs. 8 to 13, a description will now be given of a method of producing a display label as a display body, which includes the first laminate 21 or the second laminate 22, and a method of using the display label. In the description below, a method of producing a display label as a display body, which includes the second laminate 22 and a method of using the display label are described.

As illustrated in Fig. 8, a surface of the second substrate 13 on a side opposite to the front surface 13S is a rear surface 13R, and a bonding layer 31 is formed on the rear surface 13R of the second substrate 13. For the bonding layer 31, a tackifier or an adhesive may be used. The bonding layer 31 has a thickness of 1 µm or more and 25 µm or less.

As illustrated in Fig. 9, a release layer 32 is formed on a surface of the bonding layer 31 on a side opposite to that in contact with the second substrate 13. The release layer 32 may be a layer that can be released from the bonding layer 31. Thus, a display label 30 including the second laminate 22, the bonding layer 31, and the release layer 32 is obtained. As materials to form the release layer 32, a curable resin and a thermoplastic resin may be used. The materials to form the release layer 32 may include fluorine and silicone. The release layer 32 has a thickness of 10 µm or more and 80 µm or less.

As illustrated in Fig. 10, in use of the display label 30, a base material 41, for example, an article such as a card made of a resin is first prepared. The release layer 32 included in the display label 30 is then released from the bonding layer 31, and the laminate including the second laminate 22 and the bonding layer 31 is adhered to the base material 41 via the bonding layer 31. The materials to form the base material 41 are not limited to resins and may be metal and the like, and the base material 41 is not limited to a card and may be another article.

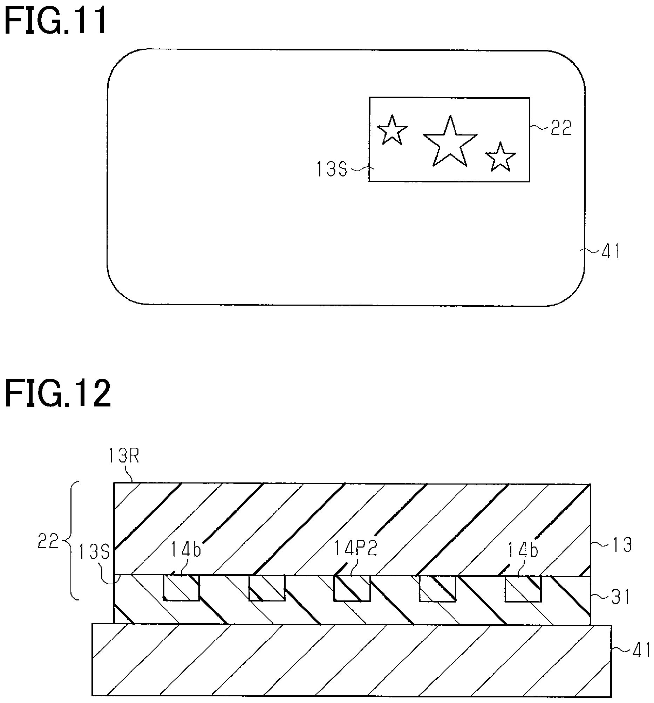

In this manner, as illustrated in Fig. 11, in the plan view facing the front surface 13S of the second substrate 13, the second laminate 22 can be adhered to part of the base material 41 via the bonding layer 31. In the plan view facing the front surface 13S of the second substrate 13, the second laminate 22 may also be adhered to the entire base material 41.

A side of the second laminate 22, which faces away from the base material 41 is an observation side, and an image displayed by the second pattern layer 14P2 can be visually recognized when the second laminate 22 is observed in the presence of light. Alternatively, a side of the base material 41, which faces away from the second laminate 22 may be the observation side. In this case, the base material 41, the bonding layer 31, and the second substrate 13 respectively may have light transmissivity. This allows an observer to visually recognize the second pattern layer 14P2 via the base material 41, the bonding layer 31, and the second substrate 13.

As illustrated in Fig. 12, the bonding layer 31 may be formed on the front surface 13S of the second substrate 13. In this case, the second substrate 13 has light transmissivity and the bonding layer 31 is formed to cover the entire second areas 14b with the bonding layer 31. In such configuration, the release layer 32 described above can be formed on a surface of the bonding layer 31 on a side opposite to that in contact with the second substrate 13 to thereby produce the display label 30 including the second laminate 22, the bonding layer 31, and the release layer 32. Then, after the release layer 32 is released from the bonding layer 31, the bonding layer 31 is adhered to the base material 41 so that the second laminate 22 is adhered to the base material 41 via the bonding layer 31.

In such a display label 30, the second areas 14b are protected by the base material 41 that is adhered via the bonding layer 31. This further allows formation of a layer having a predetermined function on the rear surface 13R of the second substrate 13. For example, on the rear surface 13R of the second substrate 13, an image receiving layer to which characters and images can be provided may be formed by a predetermined printing method, or a hard coating layer which protects each layer of the display body from being scratched may be formed. Also for example, on the rear surface 13R of the second substrate 13, a layer that contains various types of filler and a resin may be formed, or an ultraviolet absorbing layer that contains a substance to absorb ultraviolet light may be formed. On the rear surface 13R of the second substrate 13, two or more of these layers may be formed.

A side of the second laminate 22, which faces away from the base material 41 is an observation side, and an image displayed by the second pattern layer 14P2 can be visually recognized when the second laminate 22 is observed in the presence of light. Alternatively, a side of the base material 41, which faces away from the second laminate 22 may be the observation side. In this case, the base material 41 and the bonding layer 31 may have light transmissivity, while the second substrate 13 may have no light transmissivity.

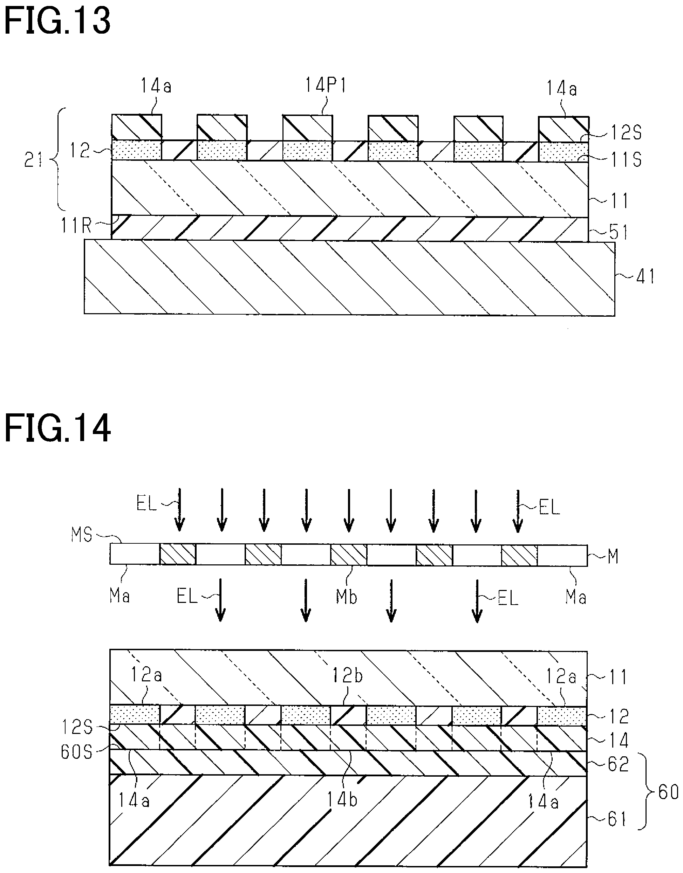

As illustrated in Fig. 13, a surface of the first substrate 11 on a side opposite to the front surface 11S is a rear surface 11R. When a display label is formed using the first laminate 21, a bonding layer 51 may be formed on the rear surface 11R of the first substrate 11. Then, a release layer can be formed on a surface of the bonding layer 51 on a side opposite to that in contact with the first substrate 11 to thereby produce a display label including the first laminate 21. In such a display label, the release layer that is in contact with the bonding layer 51 is released to allow the first laminate 21 to be adhered to the base material 41 via the bonding layer 51.

A side of the first laminate 21, which faces away from the base material 41 is the observation side, and an image displayed by the first pattern layer 14P1 can be visually recognized when the first laminate 21 is observed in the presence of light. Alternatively, a side of the base material 41, which faces away from the first laminate 21 may be the observation side. In this case, the base material 41, the bonding layer 51, the first substrate 11, and the resin layer 12 respectively may have light transmissivity. An observer is thus allowed to visually recognize the first pattern layer 14P1 via the base material 41, the bonding layer 51, the first substrate 11, and the resin layer 12.

In a display label including the first laminate 21 as well, the bonding layer 51 can be formed on the front surface 12S of the resin layer 12 as with the display label including the second laminate 22 described above. In such a configuration, a side of the first laminate 21, which faces away from the base material 41 may be the observation side, or a side of the base material 41, which faces away from the first laminate 21 may be the observation side. In either case, the areas placed closer to the observation side than the first pattern layer 14P1 is may have light transmissivity.

### [Materials to form display body]

The first substrate 11 may be transparent to the radiation EL. The first substrate 11 may be, for example, cellophane or may be a resin film or a resin sheet formed from a thermoplastic resin. As the thermoplastic resin to form the resin film or the resin sheet, for example, polycarbonate (PC), polyethylene (PE), polypropylene (PP), polyolefin (PO), ethylene vinyl alcohol (EVOH), polyvinyl alcohol (PVA), polyvinyl chloride, polyethylene terephthalate (PET), nylon, an acrylic resin, triacetylcellulose (TAC), and the like may be used. The first substrate 11 may have a thickness of 10 µm or more and 1 m or less.

As the radiation EL to cure the resin layer 12, any of, for example, an electron beam, ultraviolet light, and a laser beam may be used as described above. As the materials to form the resin layer 12, any of, for example, a resin curable by irradiation with an electron beam, a resin curable by irradiation with ultraviolet light, and a resin curable by irradiation with a laser beam may be used.

The materials to form the resin layer 12 may include a thermoplastic resin in addition to the resin curable by irradiation with the radiation EL described above. By providing the thermoplastic resin in the resin layer 12, it is possible to enhance the adhesion, in other words adhesion strength, between the first substrate 11 and the resin layer 12. The resin layer 12 has a thickness of 1 µm or more and 30 µm or less.

As the thermoplastic resin, at least one of, for example, an acrylic resin, an acrylonitrile-based resin, an acrylonitrile polystyrene copolymer, an epoxy-based resin, a polycarbonate-based resin, a cycloolefin-based resin, a polyester-based resin, a styrene-based resin, an acryl/styrene copolymer resin, or the like may be used.

As the second substrate 13, a resin film or a resin sheet may be used. As the materials to form the second substrate 13, at least one of, for example, an acrylic resin, an acrylonitrile-based resin, an acrylonitrile polystyrene copolymer, an epoxy-based resin, a polycarbonate-based resin, a cycloolefin-based resin, a polyester-based resin, a styrene-based resin, an acryl/styrene copolymer resin, and the like may be used. The second substrate 13 may have a thickness of 10 µm or more and 1 mm or less.

As the materials to form the patterning target layer 14, for example, materials containing a thermoplastic resin may be used. From the perspective of increasing strong adhesion, that is, the adhesion strength, between the patterning target layer 14 and the resin layer 12, the materials to form the patterning target layer 14 preferably contain a resin curable by irradiation with the radiation EL. The patterning target layer 14 has a thickness of 0.5 µm or more and 25 µm or less.

For example, when the materials to form the resin layer 12 contain a resin curable by irradiation with ultraviolet light, the materials to form the patterning target layer 14 preferably contain a resin curable by irradiation with ultraviolet light. When the materials to form the resin layer 12 contain a resin curable by irradiation with an electron beam, the materials to form the patterning target layer 14 preferably contain a resin curable by irradiation with an electron beam. When the materials to form the resin layer 12 contain a resin curable by irradiation with a laser beam, the materials to form the patterning target layer 14 preferably contain a resin curable by irradiation with a laser beam. As another example, the materials to form the patterning target layer 14 may contain a resin curable by irradiation with the radiation EL while they may contain no thermoplastic resin.

The patterning target layer 14 may contain a magnetic material in addition to at least one of the thermoplastic resins described above and a resin curable by irradiation with the radiation EL. As the magnetic material, at least one of, for example, a soft magnetic material, a hard magnetic material, and a magnetostrictive material may be used. These magnetic materials may be ground into powder to be added to a resin containing at least one of the thermoplastic resin described above and the resin curable by irradiation with the radiation.

The patterning target layer 14 containing a magnetic material allows magnetic information to be given to the patterning target layer 14, and thus allows reading of the information given to the patterning target layer 14 using a device capable of reading magnetic information.

The patterning target layer 14 containing a magnetic material also allows orientation of the magnetic material in the patterning target layer 14 by, after the patterning target layer 14 is formed on the second substrate 13, applying a magnetic field to the patterning target layer 14.

The patterning target layer 14 may contain at least one of coloring pigments and coloring dye in addition to at least one of the thermoplastic resin and the resin curable by irradiation with the radiation EL. This allows the color of the coloring pigments or the coloring dye to be given to the patterning target layer 14.

The patterning target layer 14 may contain a light emitting substance emitting light having a predetermined wavelength in addition to at least one of the thermoplastic resin and the resin curable by irradiation with the radiation. As the light emitting substance, a substance may be used that, for example, absorbs light having a specific wavelength and emits light having a wavelength different from that of the light at a peak absorption wavelength. Examples of the light emitting substance include fluorescent materials and phosphorescent materials. Examples of the fluorescent materials include organic fluorescent pigments, organic fluorescent dyes, and inorganic fluorescent pigments. For the organic colorant used as the fluorescent dye, a cyanin colorant, a coumarin colorant, a rhodamine colorant, and the like may be used.

As the materials to form the bonding layers 31 and 51, any of an adhesive and a tackifier may be used as described above, and for example, any resin-based tackifier and adhesive, such as acryl- and urethane-based ones, may be used.

For example, as the acrylic tackifier, a tackifier may be used in which an acrylic polymer is appropriately crosslinked. As the acrylic polymer, for example, an isocyanate compound, an epoxy-based compound, an aziridine compound, and the like may be used. Among them, as the isocyanate compound, for example, aromatic isocyanates, such as tolylene diisocyanate and xylene diisocyanate, alicyclic isocyanates, such as isophorone diisocyanate, and aliphatic isocyanates, such as hexamethylene diisocyanate, may be used.

When such an acrylic polymer is crosslinked, a carboxyl group, a hydroxyl group, an amino group, an amide group, or the like is appropriately added as a crosslinking base to the acrylic polymer such as an isocyanate compound, an epoxy-based compound, and an aziridine compound. A compound having a functional group capable of reacting with the crosslinking base, that is, a crosslinking agent is then added.

In accordance with a function intended to be given to the bonding layers 31 and 51, the materials to form the bonding layers 31 and 51 may contain materials, in addition to either one of the adhesive and the tackifier described above, different from them.

As described above, according to the first embodiment of the method of producing a display body, display intermediate, and display body, it is possible to obtain the following effects. (1) Since the method of producing a display body does not require heating of the elements constituting the display body or immersion of elements constituting the display body in acid or alkali for patterning of the patterning target layer 14, it is possible to relax the restrictions on chemical resistance and heat resistance of the materials to form the display body.

### [Modification of First Embodiment]

The first embodiment described above may be carried out by appropriate modification as follows. The first substrate 11 may be configured from a single layer as described above or may be configured from a plurality of layers. If the first substrate 11 is formed from a plurality of layers, at least two layers may be included that have materials to form each layer different from each other. If the first substrate 11 is formed from a plurality of layers, out of the layers configuring the first substrate 11, a surface in contact with the resin layer 12 in the layer adjacent to the resin layer 12 is the front surface 11S of the first substrate 11.

The resin layer 12 may be configured from a single layer as described above or may be configured from a plurality of layers. If the resin layer 12 is formed from a plurality of layers, at least two layers may be included that have materials to form each layer different from each other.

After the patterning target layer 14 is formed on the second substrate 13, the resin layer 12 may be formed on the patterning target layer 14 to contact the patterning target layer 14 with the resin layer 12. In this case, after the patterning target layer 14 is contacted with the resin layer 12, the first substrate 11 may be stacked on the resin layer 12. Alternatively, after the resin layer 12 is formed on the first substrate 11, the patterning target layer 14 may be formed on the resin layer 12 to contact the resin layer 12 with the patterning target layer 14. In this case, after the resin layer 12 is contacted with the patterning target layer 14, the second substrate 13 may be stacked on the patterning target layer 14. In either case, as long as the plurality of cured portions 12a are formed by irradiating the resin layer 12 with the radiation EL, the effects equivalent to (1) above can be obtained.

As illustrated in Fig. 14, a second substrate 60 may be configured from a plurality of layers and may be configured from, for example, a support layer 61 and an adjustment layer 62. The support layer 61 may have configuration equivalent to that of the second substrate 13 described above. The adjustment layer 62 is a layer to adjust strong adhesion, that is, adhesion strength between the front surface 60S of the second substrate 60 and the patterning target layer 14.

The adjustment layer 62 adjusts the adhesion strength to establish higher adhesion strength between the cured portions 12a and the patterning target layer 14 than adhesion strength between the front surface 60S of the second substrate 60 and the patterning target layer 14 and to establish lower adhesion strength between the uncured portions 12b and the patterning target layer 14 than the adhesion strength between the front surface 60S of the second substrate 60 and the patterning target layer 14. As materials to form the adjustment layer 62, any of an acrylic resin, an epoxy resin, a polyester resin, a urethane resin, a silicone resin, and the like may be used.

Even if the second substrate 60 is configured from the support layer 61 and the adjustment layer 62, irradiation of the resin layer 12 with the radiation EL via the mask M allows formation of the cured portions 12a and the uncured portions 12b in the resin layer 12.

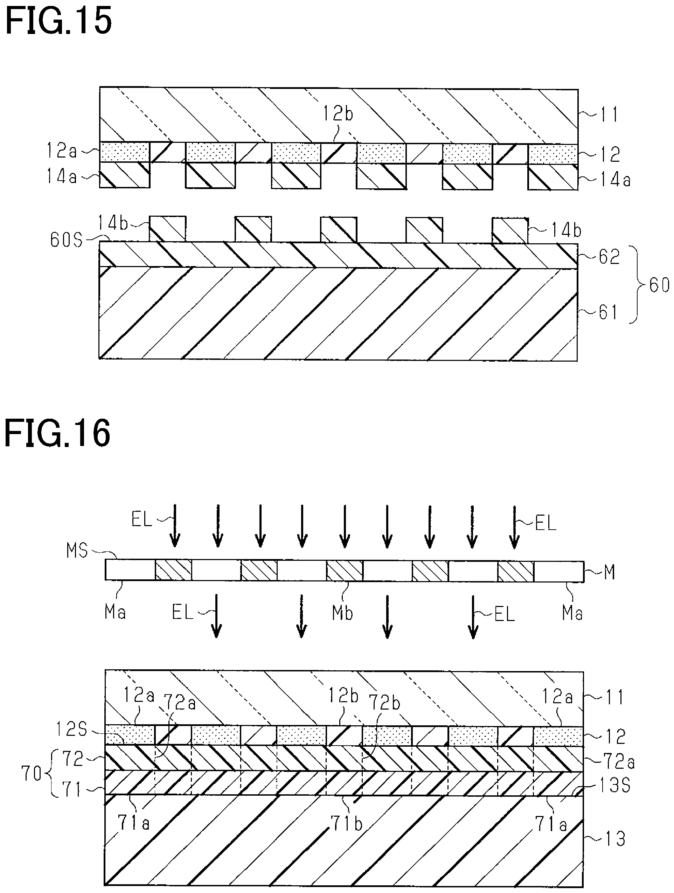

As illustrated in Fig. 15, separation of the resin layer 12 from the patterning target layer 14 causes the first areas 14a in the patterning target layer 14 to be separated from the second substrate 60 together with the resin layer 12. Meanwhile, the second areas 14b in the patterning target layer 14 remain placed on the adjustment layer 62.

The adjustment layer 62 may be a layer having a visual effect different from that of the second areas 14b in addition to the function to adjust the adhesion strength. Alternatively, the second substrate 60 may include a layer having a visual effect different from that of the second areas 14b in addition to the adjustment layer 62.

If a laminate including the support layer 61, the adjustment layer 62, and the second areas 14b is attached to a base material, a surface on an opposite side to the adjustment layer 62 in the support layer 61 may be adhered to the base material via a bonding layer or a surface of the second areas 14b in the adjustment layer 62 may be adhered to a base material via a bonding layer.

If the support layer 61 is adhered to a base material, a side of the second substrate 60, which faces away from the base material may be the observation side, or a side of the base material, which faces away from the second substrate 60 may be the observation side. If the adjustment layer 62 is adhered to a base material, a side of the second substrate 60, which faces away from the base material may be the observation side, or a side of the base material, which faces away from the second substrate 60 may be the observation side. In either case, areas placed closer to the observation side than the second areas 14b are may have light transmissivity.

As illustrated in Fig. 16, a patterning target layer 70 may be configured from a plurality of layers and may be configured from, for example, an adjustment layer 71 and a pattern formation layer 72. The pattern formation layer 72 may have configuration equivalent to that of the patterning target layer 14 described above. The adjustment layer 71 is a layer to adjust strong adhesion, that is, adhesion strength between the front surface 13S of the second substrate 13 and the patterning target layer 70.

The adjustment layer 71 adjusts the adhesion strength to establish higher adhesion strength between the cured portions 12a and the patterning target layer 70 than adhesion strength between the front surface 13S of the second substrate 13 and the patterning target layer 70 and to establish lower adhesion strength between the uncured portions 12b and the patterning target layer 70 than the adhesion strength between the front surface 13S of the second substrate 13 and the patterning target layer 70.

As materials to form the adjustment layer 71, at least one of an acrylic resin, an epoxy resin, a polyester resin, a urethane resin, a silicone resin, and the like may be used. The materials to form the adjustment layer 71 may contain, for example, microparticles, a fluorine-based resin, a mold release agent, oil, wax, and the like to reduce the adhesion, that is, adhesion strength, between the adjustment layer 71 and the second substrate 13. If the materials to form the adjustment layer 71 contain a resin other than a silicone resin, the adjustment layer 71 containing a silicone resin allows reduction of the adhesion between the adjustment layer 71 and the second substrate 13 in comparison with the case of not containing a silicone resin.

Even if the patterning target layer 70 is configured from the adjustment layer 71 and the pattern formation layer 72, irradiation of the resin layer 12 with the radiation EL via the mask M allows formation of the cured portions 12a and the uncured portions 12b. In a stacking direction of the pattern formation layer 72 and the adjustment layer 71, in the pattern formation layer 72, areas overlapping the cured portions 12a are first areas 72a and areas overlapping the uncured portions 12b are second areas 72b. In the stacking direction of the pattern formation layer 72 and the adjustment layer 71, in the adjustment layer 71, areas overlapping the cured portions 12a are first areas 71a and areas overlapping the uncured portions 12b are second areas 71b.

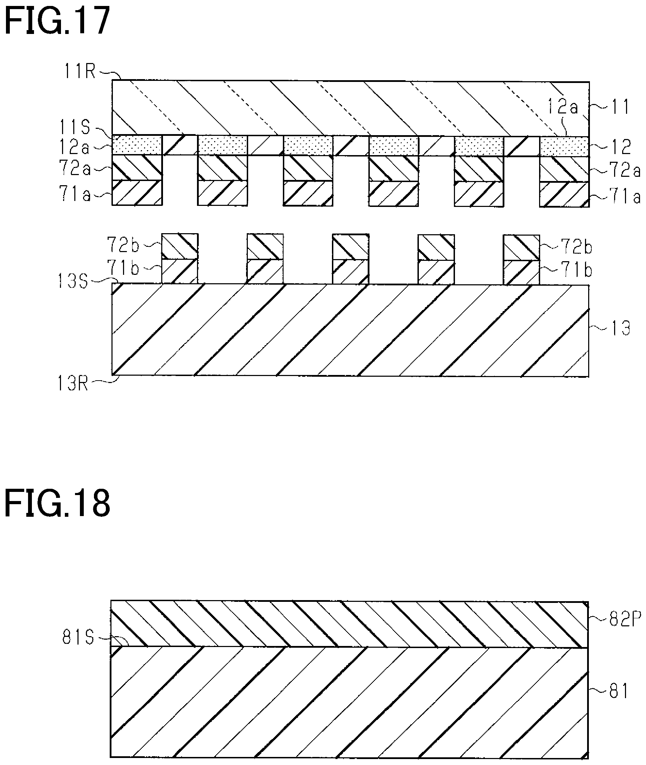

As illustrated in Fig. 17, separation of the resin layer 12 from the patterning target layer 70 causes the first areas 72a in the pattern formation layer 72 and the first areas 71a in the adjustment layer 71 to be separated from the second substrate 13 together with the resin layer 12. Meanwhile, in a thickness direction of the second substrate 13, the second areas 72b of the pattern formation layer 72 remain placed on the second substrate 13 in a state of overlapping the second areas 71b of the adjustment layer 71.

The adjustment layer 71 may be a layer having a visual effect different from that of the second areas 72b of the pattern formation layer 72 in addition to the function to adjust the adhesion strength. Alternatively, the patterning target layer 70 may include a layer having a visual effect different from that of the pattern formation layer 72 addition to the adjustment layer 71.

If a laminate including the second substrate 13, the second areas 71b of the adjustment layer 71, and the second areas 72b of the pattern formation layer 72 is attached to a base material, the rear surface 13R of the second substrate 13 may be adhered to a base material using a bonding layer or the front surface 13S of the second substrate 13 may be adhered to a base material using a bonding layer.

If the rear surface 13R of the second substrate 13 is adhered to a base material, a side of the second substrate 13, which faces away from the base material may be the observation side, or a side of the base material, which faces away from the second substrate 13 may be the observation side. If the front surface 13S of the second substrate 13 is adhered to a base material, a side of the second substrate 13, which faces away from the base material may be the observation side, or a side of the base material, which faces away from the second substrate 13 may be the observation side. In either case, areas placed closer to the observation side than the second areas 72b of the pattern formation layer 72 are may have light transmissivity.

If a laminate including the first substrate 11, the resin layer 12, the first areas 72a of the pattern formation layer 72, and the first areas 71a of the adjustment layer 71 is attached to a base material, the rear surface 11R of the first substrate 11 may be adhered to the base material via a bonding layer or the front surface 12S of the resin layer 12 may be adhered to the base material via a bonding layer.

If the rear surface 11R of the first substrate 11 is adhered to a base material, a side of the first substrate 11, which faces away from the base material may be the observation side, or a side of the base material, which faces away from the first substrate 11 may be the observation side. If the front surface 12S of the resin layer 12 is adhered to a base material, a side of the resin layer 12, which faces away from the base material may be the observation side, or a side of the base material, which faces away from the resin layer 12 may be the observation side. In either case, areas placed closer to the observation side than the first areas 72a of the pattern formation layer 72 are may have light transmissivity.

If the patterning target layer 70 is configured from a plurality of layers, the patterning target layer 70 is a layer to cover the pattern formation layer 72 described above and may have a layer allowing protection of the pattern formation layer 72.

On the rear surface 11R of the first substrate 11 as well, similar to the rear surface 13R of the second substrate 13, a layer having a predetermined function may be formed, such as an image receiving layer, a hard coating layer, a layer containing various types of filler and a resin, and an ultraviolet absorbing layer.

By patterning of the patterning target layer 14, a plurality of micropatterns aligned with a predetermined pitch may be formed as the plurality of first areas 14a or the plurality of second areas 14b. In such configuration, by providing lenses over the first laminate 21 or the second laminate 22 having micropatterns, with a pitch different from that of the micropatterns and aligned with an approximately equal pitch, it is also possible to display a stereoscopic image and moiré patterns. In addition, according to a display body including such first laminate 21 or second laminate 22, it is also possible to determine the authenticity of the base material 41 to which the display body is imparted on the basis of whether the display body is capable of displaying a stereoscopic image or moiré patterns.

### [Second embodiment]

With reference to Figs. 18 to 22, a second embodiment is described embodying a method of producing a display body, a display intermediate, and a display body. The display intermediate and the display body do not form part of the invention as defined by the claims. The second embodiment is different in the configuration of a patterning target layer in comparison with the first embodiment. Accordingly, in the description below, such differences are described in detail and the configuration in common with the first embodiment is omitted from the detailed description by giving the same reference signs as the first embodiment. In the description below, a method of producing a display body and materials to form the display body are described in order.

### [Method of Producing Display Body]

In a method of producing a display body in the second embodiment, formation of a patterning target layer includes formation of a reflective layer.

With reference to Figs. 18 to 22, a more detailed description is given below to the method of producing a display body. As illustrated in Fig. 18, a support layer 81 is prepared and a precursor layer 82P is formed as a precursor of a relief structure layer (or a projection-recess structure layer) on a front surface 81S of one surface of the support layer 81. For the support layer 81, configuration equivalent to that of the second substrate 13 in the first embodiment described above may be used. As materials to form the precursor layer 82P, various resins may be used.

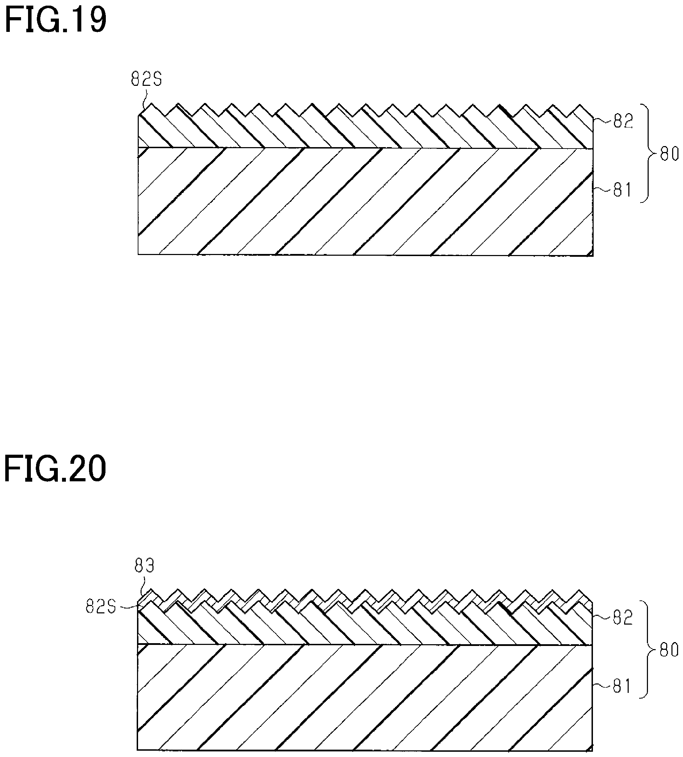

As illustrated in Fig. 19, a relief structure layer 82 having a relief surface (or a projection-recess surface) 82S as a surface on an opposite side to the surface in contact with the support layer 81 is formed from the precursor layer 82P. For formation of the relief structure layer 82, a stamp or the like as an original plate for the relief structure layer 82 is pressed against a surface of the precursor layer 82P on a side opposite to that in contact with the support layer 81, and the precursor layer 82P is cured in this state. Alternatively, a stamp may be pressed against a surface of the precursor layer 82P on a side opposite to that in contact with the support layer 81, and the stamp may be released from the support layer 81, followed by curing of the precursor layer 82P. The relief structure layer 82 is thus obtained to which the relief structure (or the projection-recess structure) of the stamp is transferred. The relief structure layer 82 and the support layer 81 thus formed configure a second substrate 80 and the relief surface 82S is an example of a front surface of the second substrate 80.

The relief structure layer 82 is configured to emit diffracted light by a cycle of projections and recesses of the relief surface 82S. The relief surface 82S functions as a diffraction grating, and for example in the relief surface 82S, the projections and the recesses are alternately aligned with a predetermined cycle and the projections and the recesses extend in a direction orthogonal to the direction of alignment.

As illustrated in Fig. 20, a reflective layer 83 as an example of a patterning target layer is formed on the relief surface 82S of the relief structure layer 82. Materials to form the reflective layer 83 may contain metal or may contain a dielectric. The reflective layer 83 has a higher reflectance than that of the relief surface 82S of the relief structure layer 82 and the reflective layer 83 has a relief structure similar to that of the relief surface 82S.

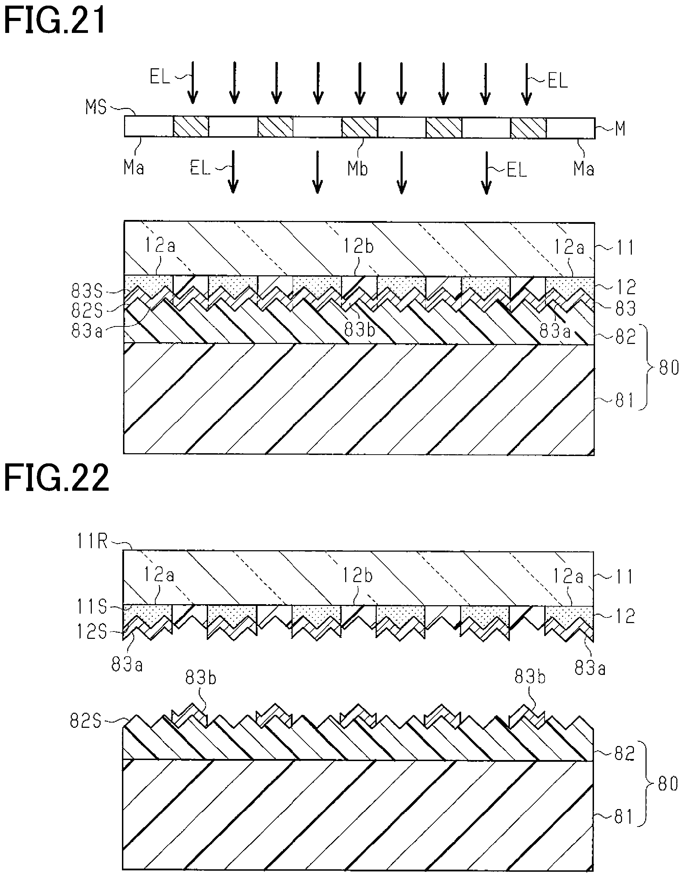

As illustrated in Fig. 21, a surface of the reflective layer 83 on a side opposite to that in contact with the relief structure layer 82 is a front surface 83S, and the front surface 83S of the reflective layer 83 is in contact with the resin layer 12. The resin layer 12 is then irradiated with the radiation EL via the mask M to cure part of the resin layer 12 and thus the plurality of cured portions 12a are formed. The cured portions 12a of the resin layer 12 thus adhere to the reflective layer 83 while the uncured portions 12b remain in contact with the reflective layer 83.

In a plan view facing the front surface 83S of the reflective layer 83, areas overlapping the cured portions 12a of the resin layer 12 in the reflective layer 83 are first areas 83a and areas overlapping the uncured portions 12b of the resin layer 12 are second areas 83b.

In this situation, adhesion strength between the cured portions 12a and the reflective layer 83 is higher than adhesion strength between the relief surface 82S, as a front surface of the second substrate 80, and the reflective layer 83; and adhesion strength between the uncured portions 12b and the reflective layer 83 is lower than the adhesion strength between the relief surface 82S and the reflective layer 83.

In other words, respective materials to form the first substrate 11, the resin layer 12, the support layer 81, the relief structure layer 82, and the reflective layer 83 may be selected to establish the relationships of the adhesion strength described above between the resin layer 12, the second substrate 80, and the reflective layer 83 after irradiating the resin layer 12 with the radiation EL.

As illustrated in Fig. 22, separation of the resin layer 12 from the reflective layer 83 causes the first areas 83a in the reflective layer 83 to be separated together with the resin layer 12. In the reflective layer 83, the first areas 83a are thus placed on the front surface 12S of the resin layer 12 while the second areas 83b remain placed on the relief surface 82S of the relief structure layer 82.

According to such a method of producing a display body, it is possible to provide a visual effect by the patterned reflective layer 83 to the display body. Even in a configuration including the reflective layer 83 formed from a metal layer and the like, the reflective layer 83 is not patterned using acid or alkali and it is thus possible to relax the restrictions on chemical resistance in the materials to form the display body during patterning of the display body.

If a second laminate including the second substrate 80 and the second areas 83b of the reflective layer 83 is attached to a base material, a surface of the support layer 81, which faces away from the relief structure layer 82 may be adhered to the base material via a bonding layer, or the relief surface 82S of the relief structure layer 82 may be adhered to the base material via a bonding layer.

If the support layer 81 is adhered to a base material, a side of the support layer 81, which faces away from the base material may be the observation side, or a side of the base material, which faces away from the support layer 81 may be the observation side. If the relief structure layer 82 is adhered to a base material, a side of the relief structure layer 82, which faces away from the base material may be the observation side, or a side of the base material, which faces away from the relief structure layer 82 may be the observation side. In either case, areas placed closer to the observation side than the second areas 83b of the reflective layer 83 are may have light transmissivity.

If a first laminate including the first substrate 11, the resin layer 12, and the first areas 83a of the reflective layer 83 is attached to a base material, the rear surface 11R of the first substrate 11 may be adhered to the base material via a bonding layer or the front surface 12S of the resin layer 12 may be adhered to the base material via a bonding layer.

If the rear surface 11R of the first substrate 11 is adhered to a base material, a side of the first substrate 11, which faces away from the base material may be the observation side, or a side of the base material, which faces away from the first substrate 11 may be the observation side. If the front surface 12S of the resin layer 12 is adhered to a base material, a side of the resin layer 12, which faces away from the base material may be the observation side, or a side of the base material, which faces away from the resin layer 12 may be the observation side. In either case, areas placed closer to the observation side than the first areas 83a of the reflective layer 83 are may have light transmissivity.

### [Materials to form display body]

As materials to form the relief structure layer 82, that is, precursor layer 82P forming materials, an ultraviolet curable resin or a thermoplastic resin may be used and a mixture of them may be used as well. The relief structure layer 82 has a thickness of 0.5 µm or more and 25 µm or less.

The materials to form the reflective layer 83 may contain metal as described above, and if the materials to form the reflective layer 83 contain metal, at least one metal selected from the group consisting of, for example, Al, Sn, Cr, Ni, Cu, Au, Ag, and the like or a compound of at least one metal selected from this group may be used as the materials to form the reflective layer 83.

The reflective layer 83 may be a transparent layer, and such a transparent reflective layer 83 is approximately transparent to light perpendicular to one surface of the reflective layer 83 while exhibiting reflection properties to oblique light forming a predetermined angle other than the perpendicular angle to this surface in accordance with the refractive index to the oblique light.

Such a reflective layer 83 may be formed from a single layer or may be formed from a plurality of layers. As materials to form each layer in the reflective layer 83, any of, for example, ceramic as a dielectric and an organic polymer may be used.

If the material to form each layer in the reflective layer 83 is ceramic, any of, for example, Fe₂O₃, TiO₂, CdS, CeO₂, ZnS, PbCl₂, CdO, WO₃, SiO, Si₂O₃, In₂O₃, PbO, Ta₂O₃, ZnO, ZrO₂, MgO, SiO₂, MgF₂, CeF₃, CaF₂, AlF₃, Al₂O₃, GaO, and the like may be used as the material to form each layer.

If the material to form each layer in the reflective layer 83 is an organic polymer, for example, polyethylene, polypropylene, polytetrafluoroethylene, polymethyl methacrylate, polystyrene, and the like may be used as the material to form each layer.

When the materials to form the reflective layer 83 are a metal, metal compound, and ceramics described above, vacuum deposition, sputtering, CVD, and the like may be used as a method of forming the reflective layer 83. Meanwhile, when the materials to form the reflective layer 83 are an organic polymer, various printing methods and the like may be used as a method of forming the reflective layer 83. The reflective layer 83 has a thickness of, for example, 50 Å or more and 10000 Å or less.

As having described above, according to the second embodiment of the method of producing a display body, the display intermediate, and the display body, it is possible to obtain the following effects in addition to (1) above. (2) It is possible to give a visual effect by the patterned reflective layer 83 to the display body.

### [Modification of second embodiment]

The second embodiment described above may be carried out by appropriate modification as follows. - The second substrate 80 may be configured from a plurality of layers and configured to have a surface to form the reflective layer 83 in the second substrate 80 as a flat surface. Even in such configuration, it is possible to pattern the reflective layer 83 and thus the effects equivalent to (2) above can be obtained. Alternatively, the second substrate 80 may be configured from a single layer and configured to have a surface to form the reflective layer 83 in the second substrate 80 as a relief surface.

The second substrate 80 may include another layer placed between the support layer 81 and the relief structure layer 82 and may include, for example, an anchor layer having a function of increasing adhesion strength of the relief structure layer 82 to the support layer 81.

The patterning target layer may include, in addition to the reflective layer 83 described above, at least one of a layer placed between the reflective layer 83 and the relief structure layer 82 and a layer positioned on a surface of the reflective layer 83 on a side opposite to that in contact with the relief structure layer 82. These layers preferably have light transmissivity capable of transmitting diffracted light emitted from the reflective layer 83.

The layer placed between the reflective layer 83 and the relief structure layer 82 may be, for example, an adjustment layer to adjust strong adhesion, that is, adhesion strength between the reflective layer 83 and the relief structure layer 82, and in more detail, may be a layer to reduce the adhesion strength of the reflective layer 83 to the relief structure layer 82. The layer positioned on a surface of the reflective layer 83, which faces away from the relief structure layer 82 may be, for example, a protective layer to protect the reflective layer 83.

### [Third embodiment]

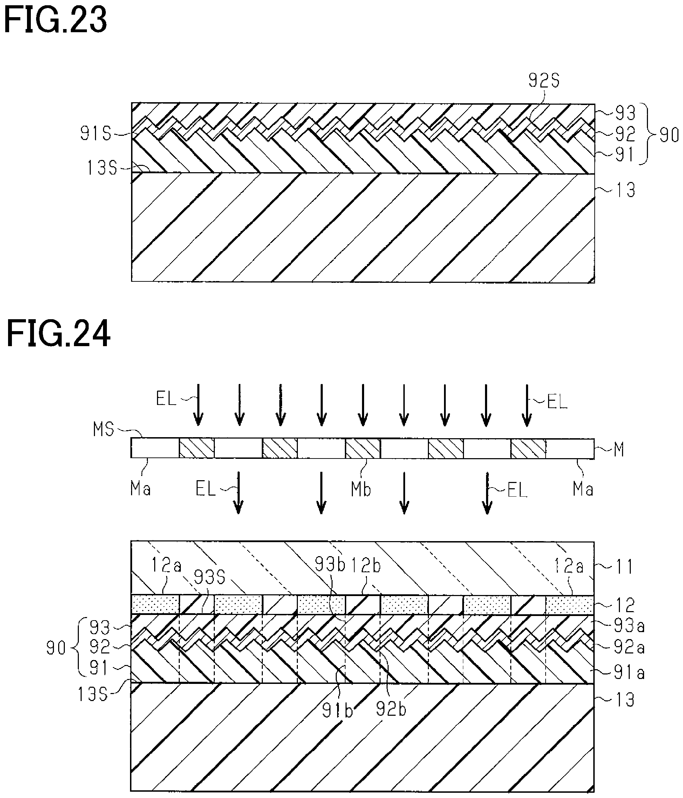

With reference to Figs. 23 to 25, a third embodiment is described embodying a method of producing a display body, a display intermediate, and a display body. The display intermediate and the display body do not form part of the invention as defined by the claims. The third embodiment is different in the configuration of the patterning target layer in comparison with the first embodiment. Accordingly, in the description below, such differences are described in detail and the configuration in common with the first embodiment is omitted from the detailed description by giving the same reference signs as the first embodiment. In the description below, a method of producing a display body and materials to form the display body are described in order.

### [Method of Producing Display Body]

In the method of producing a display body in the third embodiment, formation of a patterning target layer is to form a relief structure layer on a surface of a substrate and includes formation of a surface of the relief structure layer, which faces away from the substrate as a relief surface configured to emit diffracted light by a cycle of projections and recesses, and formation of a reflective layer to cover the relief surface.

With reference to Figs. 23 to 25, a method of producing a display body is described below in more detail. As illustrated in Fig. 23, the second substrate 13 is prepared and a relief structure layer 91 is formed on the front surface 13S of the second substrate 13. In the relief structure layer 91, a surface on a side opposite to that in contact with the second substrate 13 is a relief surface 91S, and a reflective layer 92 is formed on the relief surface 91S. In the reflective layer 92, a surface on a side opposite to that in contact with the relief structure layer 91 is a front surface 92S, and a protective layer 93 is formed on the front surface 92S. A patterning target layer 90 configured from three layers is thus formed on the front surface 13S of the second substrate 13.

The relief structure layer 91 may be formed by a method equivalent to that of the relief structure layer 82 in the second embodiment described above, and the reflective layer 92 may also be formed by a method equivalent to that of the reflective layer 83 in the second embodiment described above.

The protective layer 93 has light transmissivity, and as materials to form the protective layer 93, various resins may be used. The protective layer 93 may have a function as an adjustment layer to adjust strong adhesion, that is, adhesion strength between the reflective layer 92 and the resin layer 12.

As illustrated in Fig. 24, in the protective layer 93, a surface on a side opposite to that in contact with the reflective layer 92 is a front surface 93S, and the front surface 93S of the protective layer 93 is in contact with the resin layer 12. The resin layer 12 is then irradiated with the radiation EL via the mask M to cure part of the resin layer 12 and thus the plurality of cured portions 12a are formed.

In plan view facing the front surface 93S of the protective layer 93, in other words, in a thickness direction of the patterning target layer 90, in the protective layer 93, areas overlapping the cured portions 12a of the resin layer 12 are first areas 93a and areas overlapping the uncured portions 12b of the resin layer 12 are second areas 93b. In plan view facing the front surface 93S of the protective layer 93, in other words, in the thickness direction of the patterning target layer 90, in the reflective layer 92, areas overlapping the cured portions 12a are first areas 92a and areas overlapping the uncured portions 12b are second areas 92b. In plan view facing the front surface 93S of the protective layer 93, in other words, in the thickness direction of the patterning target layer 90, in the relief structure layer 91, areas overlapping the cured portions 12a are first areas 91a and areas overlapping the uncured portions 12b are second areas 91b.

In this situation, adhesion strength between the cured portions 12a and the patterning target layer 90 is higher than adhesion strength between the front surface 13S of the second substrate 13 and the patterning target layer 90 and adhesion strength between the uncured portions 12b and the patterning target layer 90 is lower than the adhesion strength between the front surface 13S of the second substrate 13 and the patterning target layer 90.

In more detail, all of the adhesion strength between the cured portions 12a and the protective layer 93, the adhesion strength between the protective layer 93 and the reflective layer 92, and the adhesion strength between the reflective layer 92 and the relief structure layer 91 are higher than the adhesion strength between the relief structure layer 91 and the front surface 13S of the second substrate 13. Then, the adhesion strength between the uncured portions 12b and the protective layer 93 is lower than any of the adhesion strength between the protective layer 93 and the reflective layer 92, the adhesion strength between the reflective layer 92 and the relief structure layer 91, and the adhesion strength between the relief structure layer 91 and the front surface 13S of the second substrate 13.

In other words, respective materials to form the first substrate 11, the resin layer 12, the second substrate 13, the relief structure layer 91, the reflective layer 92, and the protective layer 93 may be selected to establish the relationships of the adhesion strengths described above between the resin layer 12, the second substrate 13, and the patterning target layer 90 after irradiating the resin layer 12 with the radiation EL.

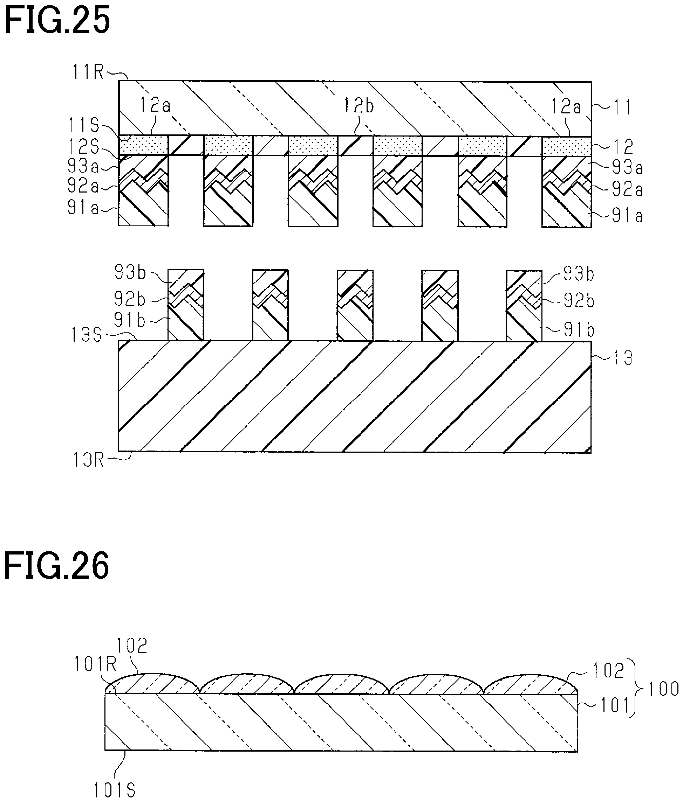

As illustrated in Fig. 25, separation of the resin layer 12 from the patterning target layer 90 causes the first areas 91a of the relief structure layer 91, the first areas 92a of the reflective layer 92, and the first areas 93a of the protective layer 93 to be separated together with the resin layer 12. The first areas in each layer constituting the patterning target layer 90 are thus placed on the front surface 12S of the resin layer 12 while the second areas in each layer constituting the patterning target layer 90 remain placed on the front surface 13S of the second substrate 13.

According to such a method of producing a display body, it is possible to pattern, after the relief structure layer 91 and the reflective layer 92 are formed, the patterning target layer 90 including them. Accordingly, it is also possible to form a layer capable of displaying diffraction images different from each other from the patterning target layer 90 including the relief structure layer 91 and the reflective layer 92 having an identical shape to each other.

If a second laminate including the second substrate 13 and the second areas in each layer of the patterning target layer 90 is attached to a base material, the rear surface 13R of the second substrate 13 may be adhered to the base material via a bonding layer or the front surface 13S of the second substrate 13 may be adhered to the base material via a bonding layer.

In each case that the rear surface 13R of the second substrate 13 is adhered to a base material and that the front surface 13S of the second substrate 13 is adhered to a base material, a side of the second substrate 13, which faces away from the base material may be the observation side, or a side of the base material, which faces away from the second substrate 13 may be the observation side. In either case, areas placed closer to the observation side than the second areas 92b of the reflective layer 92 are may have light transmissivity.

If a first laminate including the first substrate 11, the resin layer 12, and the first areas in each layer of the patterning target layer 90 is attached to a base material, the rear surface 11R of the first substrate 11 may be adhered to the base material via a bonding layer or the front surface 12S of the resin layer 12 may be adhered to the base material via a bonding layer.

In each case that the rear surface 11R of the first substrate 11 is adhered to a base material and that the front surface 12S of the resin layer 12 is adhered to a base material, a side of the first substrate 11, which faces away from the base material may be the observation side, or a side of the base material, which faces away from the first substrate 11 may be the observation side. In either case, areas placed closer to the observation side than the first areas 92a of the reflective layer 92 are may have light transmissivity.

### [Materials to form display body]

As materials to form the protective layer 93, an ultraviolet curable resin or a thermoplastic resin may be used, or a mixture of them may be used. If an optical function is intended to be given to the protective layer 93, the front surface 93S of the protective layer 93 may be a relief surface to be a surface configured to emit diffracted light by projections and recesses of the relief surface or the materials to form the protective layer 93 may have magnetic material, coloring pigments, coloring dye, fluorescent pigments, and the like added thereto.

As having described above, according to the third embodiment of the method of producing a display body, the display intermediate, and the display body, it is possible to obtain the following effects in addition to the effects of (1) described above. (3) It is also possible to form a layer capable of displaying diffraction images different from each other from the patterning target layer 90 including the relief structure layer 91 and the reflective layer 92 having an identical shape to each other.

### [Modification of third embodiment]

The third embodiment described above may be carried out by appropriate modification as follows. The second substrate 13 may be configured from a plurality of layers. For example, the second substrate 13 may have a configuration equivalent to that of the second substrate 60 in the prior description with reference to Figs. 14 and 15.

- The patterning target layer 90 may include a layer other than the three layers described above, and even in such configuration, it is possible to pattern the patterning target layer including the relief structure layer 91 and the reflective layer 92 and thus the effects equivalent to (3) above can be obtained.

The patterning target layer 90 may include no protective layer 93, and even in such configuration, it is possible to pattern the patterning target layer including the relief structure layer 91 and the reflective layer 92 and thus the effects equivalent to (3) above can be obtained.

### [Fourth embodiment]

With reference to Figs. 26 to 31, a fourth embodiment is described embodying a method of producing a display body, a display intermediate, and a display body. The display intermediate and the display body do not form part of the invention as defined by the claims. The fourth embodiment is different in that lenses are formed to focus radiation on a resin layer in comparison with the first embodiment. Accordingly, in the description below, such differences are described in detail and the configuration in common with the first embodiment is omitted from the detailed description by giving the same reference signs as the first embodiment. In the description below, a method of producing a display body and materials to form the display body are described in order.

### [Method of Producing Display Body]

The method of producing a display body in the fourth embodiment further includes: forming, prior to the forming of the cured portions, a lens array layer having a plurality of lenses to focus radiation on the resin layer; and stacking, prior to the forming of the cured portions, the lens array layer and the resin layer. Irradiation of the resin layer with radiation includes irradiating the plurality of lenses with radiation from an opposite side to a side facing the resin layer, onto the resin layer.

With reference to Figs. 26 to 31, the method of producing a display body is described below in more detail. As illustrated in Fig. 26, a support layer 101 is prepared and a plurality of cylindrical lenses 102 are formed on a rear surface 101R as one surface of the support layer 101. The cylindrical lenses 102 are examples of lenses. A lens array layer 100 is thus formed configured from the plurality of cylindrical lenses 102 and the support layer 101 to support the plurality of cylindrical lenses 102. The support layer 101 may have configuration equivalent to that of the first substrate 11 in the first embodiment described above, and as materials to form each cylindrical lens 102, various resins may be used.

The support layer 101 and the cylindrical lenses 102 may be integrally formed. For example, after a coating film is formed using a molten resin, a stamp as an original plate to form a plurality of lenses is pressed against one surface of the coating film. The coating film is cured while the stamp is pressed against the coating film and the stamp is released from the cured resin layer, and thus the lens array layer 100 is obtained having the support layer 101 and the plurality of cylindrical lenses 102. The lens array layer 100 having the support layer 101 and the plurality of cylindrical lenses 102 may be formed by curing the resin layer after releasing the stamp from the coating film.

Each cylindrical lens 102 of the lens array layer 100 is a lens to focus radiation on the resin layer 12 formed on a front surface 101S of the support layer 101. Each cylindrical lens 102 is in a shape with a focus on the resin layer 12.

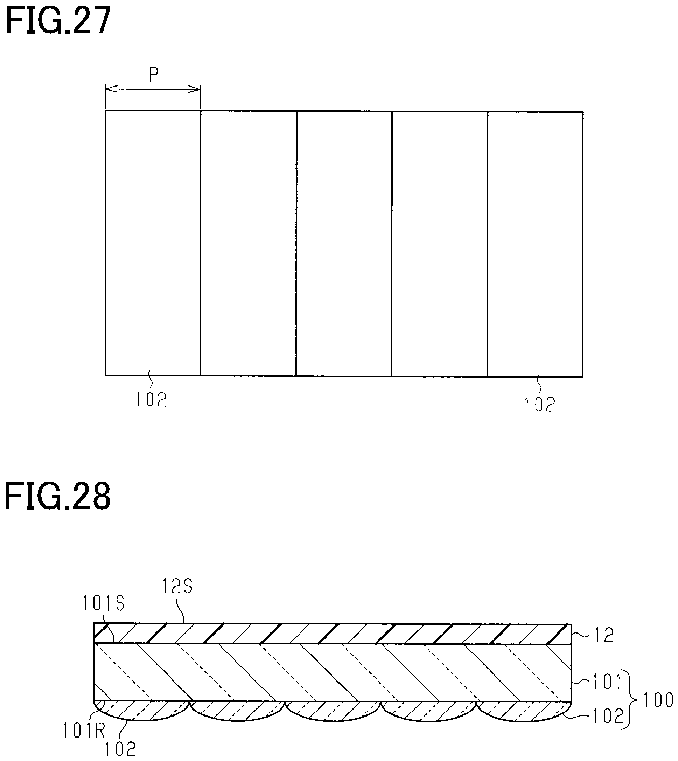

As illustrated in Fig. 27, the cylindrical lenses 102 are aligned in one direction and extend in a direction orthogonal to the direction of alignment of the cylindrical lenses 102. The plurality of cylindrical lenses 102 configure lenticular lenses. In the direction of alignment of the cylindrical lenses 102, the cylindrical lenses 102 are placed with a pitch P of preferably 5 µm or more and 300 µm or less and more preferably 10 µm or more and 200 µm or less.

The pitch P of 5 µm or more suppresses diffraction of light due to the cylindrical lenses 102 and thus can suppress reduction of the light collecting effect by the cylindrical lenses 102. The difficulty in patterning of a patterning target layer is suppressed thus because, for patterning of the patterning target layer using a resin layer, the resin layer is irradiated with an insufficient amount of light. The pitch P of 300 µm or less can suppress the difficulty in production of the lens array layer 100.

In the cylindrical lenses 102, a width of the cylindrical lenses 102, that is, a thickness of the cylindrical lenses 102 relative to the pitch P of the cylindrical lenses 102 is an aspect A. The aspect A is preferably 10% or more and 70% or less and more preferably 20% or more and 60% or less. Each of the pitch P and the aspect A may be appropriately selected in accordance with the shape, the size, and the like of the area to be irradiated with radiation in the resin layer 12.

As illustrated in Fig. 28, the resin layer 12 is formed on the front surface 101S of the support layer 101. In the resin layer 12, a surface on a side opposite to that in contact with the support layer 101 is the front surface 12S. The lens array layer 100 and the resin layer 12 are thus stacked.

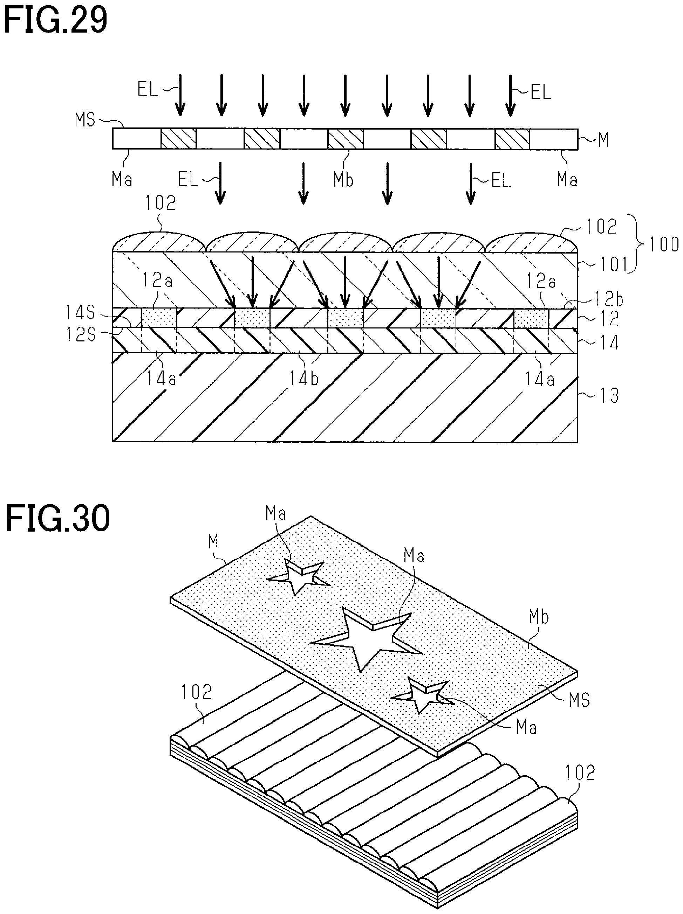

As illustrated in Fig. 29, the front surface 12S of the resin layer 12 is in contact with the front surface 14S of the patterning target layer 14. The resin layer 12 is then irradiated with the radiation EL via the mask M to cure part of the resin layer 12 and thus the plurality of cured portions 12a are formed.

In this situation, the radiation EL used for the irradiation of the resin layer 12 via the mask M are used for irradiation of the resin layer 12 via the plurality of cylindrical lenses 102. The radiations E through the transmitting areas Ma in the mask M reach the resin layer 12 in a state of having been focused by each cylindrical lens 102.

Accordingly, as illustrated in Fig. 30, in the plan view facing the front surface MS of the mask M, the entire areas overlapping the transmitting areas Ma of the mask M in the resin layer 12 are not irradiated with the radiation EL, but instead, in the resin layer 12, areas overlapping the transmitting areas Ma and to be focuses of the cylindrical lenses 102 are irradiated with the radiation EL.

The cylindrical lenses 102 have a linear focus in the extending direction of the cylindrical lenses 102. Accordingly, the resin layer 12 is irradiated with the radiation EL to draw a plurality of lines aligned in the direction of alignment of the plurality of cylindrical lenses 102 and the plurality of lines parallel to each other.

Since the resin layer 12 is irradiated with the radiation EL via the cylindrical lenses 102, in plan view facing the front surface 12S of the resin layer 12, it is also possible to define a width of the cured portions 12a in the direction of alignment of the cylindrical lenses 102 and a length of the cured portions 12a in the extending direction of the cylindrical lenses 102 respectively as approximately 1 µm.

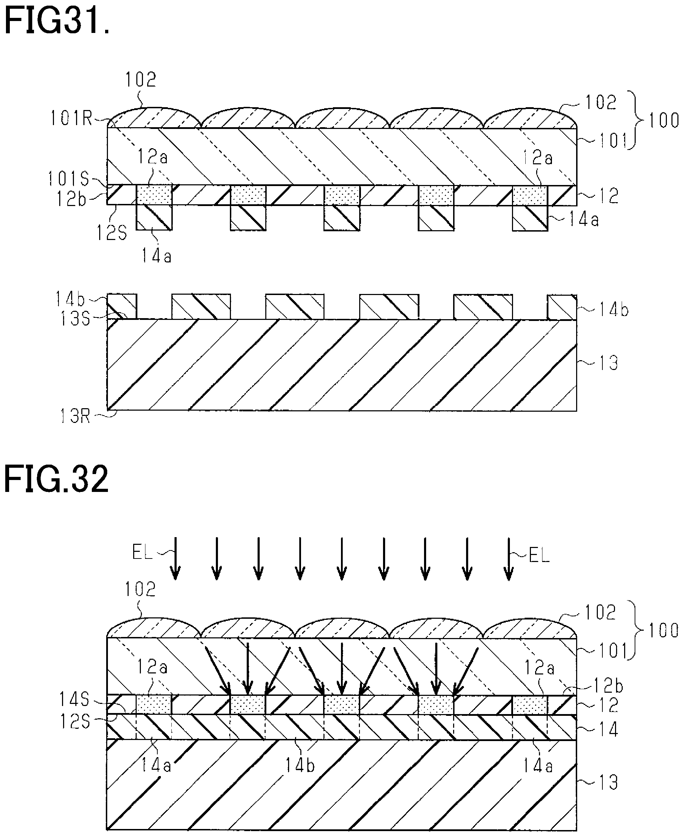

As illustrated in Fig. 31, separation of the resin layer 12 from the patterning target layer 14 causes the first areas 14a of the patterning target layer 14 to be separated together with the resin layer 12. In the patterning target layer 14, the first areas 14a are thus placed on the front surface 12S of the resin layer 12, while the second areas 14b remain placed on the front surface 13S of the second substrate 13.

As long as the patterning target layer 14 contains the coloring pigments, the coloring dye, and the light emitting substance described above, visual recognition of the first areas 14a in the direction of the normal to the front surface 12S of the resin layer 12 allows visual recognition of an image displayed by the first areas 14a. In contrast, visual recognition of the first areas 14a in a direction intersecting the normal direction to the front surface 12S of the resin layer 12 causes difficulty in visual recognition of the image displayed by the first areas 14a.

According to such a method of producing a display body, the resin layer 12 is irradiated with the radiation EL via the plurality of cylindrical lenses 102 and it is thus possible to increase the difference in the amount of the radiation EL for irradiation at the boundary in the resin layer 12 between the areas irradiated with the radiation EL and the areas not irradiated with the radiation EL. It is thus possible to increase the difference in adhesion strength to the patterning target layer 14 at the boundary between the cured portions 12a and the uncured portions 12b, and as a result, to increase accuracy of the shape of the patterning target layer 14 after patterning.

If a second laminate including the second substrate 13 and the second areas 14b of the patterning target layer 14 is attached to a base material, the rear surface 13R of the second substrate 13 may be adhered to the base material via a bonding layer or the front surface 13S of the second substrate 13 may be adhered to the base material via a bonding layer.

In each case that the rear surface 13R of the second substrate 13 is adhered to a base material and that the front surface 13S of the second substrate 13 is adhered to a base material, a side of the second substrate 13, which faces away from the base material may be the observation side, or a side of the base material, which faces away from the second substrate 13 may be the observation side. In either case, areas placed closer to the observation side than the second areas 14b of the patterning target layer 14 may have light transmissivity.

If a first laminate including the lens array layer 100, the resin layer 12, and the first areas 14a of the patterning target layer 14 is attached to a base material, the front surface 12S of the resin layer 12 may be adhered to the base material via a bonding layer.

If the front surface 12S of the resin layer 12 is adhered to a base material, a side of the lens array layer 100, which faces away from the base material is preferably the observation side. In this case, areas placed closer to the observation side than the first areas 14a of the patterning target layer 14 are may have light transmissivity.

### [Materials to form display body]

When the cylindrical lenses 102 and the support layer 101 are individually formed, an ultraviolet curable resin, for example, may be used as a material to form the cylindrical lenses 102. In this case, firstly, a coating liquid containing an ultraviolet curable resin is applied on the rear surface 101R of the support layer 101 to form a coating film on the rear surface 101R. The coating film is then irradiated with ultraviolet light while a stamp to form the cylindrical lenses 102 is pressed against one surface of coating film to cure the coating film. The stamp is released from the cured resin layer to obtain the lens array layer 100 including the plurality of cylindrical lenses 102. The lens array layer 100 including the plurality of cylindrical lenses 102 may be obtained also by curing the resin layer after the stamp is released from the coating film.

If the cylindrical lenses 102 and the support layer 101 are integrally formed, the lens array layer 100 may be formed by melt molding. In this case, as materials to form the lens array layer 100, any of, for example, an acrylic resin, an acrylonitrile-based resin, an acrylonitrile polystyrene copolymer, an epoxy-based resin, a polycarbonate-based resin, a cycloolefm-based resin, a polyester-based resin, a styrene-based resin, an acryl/styrene copolymer resin, and the like may be used.

As having described above, according to the fourth embodiment of the method of producing a display body, the display intermediate, and the display body, it is possible to obtain the following effects in addition to the effects in (1) above.

(4) It is possible to increase a difference in adhesion strength to the patterning target layer 14 at the boundary between the cured portions 12a and the uncured portions 12b, and thus accuracy of the shape of the patterning target layer 14 after patterning can be increased.

### [Modification of fourth embodiment]

The fourth embodiment described above may be carried out by appropriate modification as follows. The lens array layer 100 and the resin layer 12 may be stacked by forming the resin layer 12 on the patterning target layer 14 placed on the second substrate 13, followed by placing the support layer 101 and the plurality of cylindrical lenses 102 on the resin layer 12. Even in such configuration, as long as the plurality of cured portions 12a are formed by irradiating the resin layer 12 with the radiation EL collected by the cylindrical lenses 102, the effects equivalent to (1) and (4) above can be obtained.

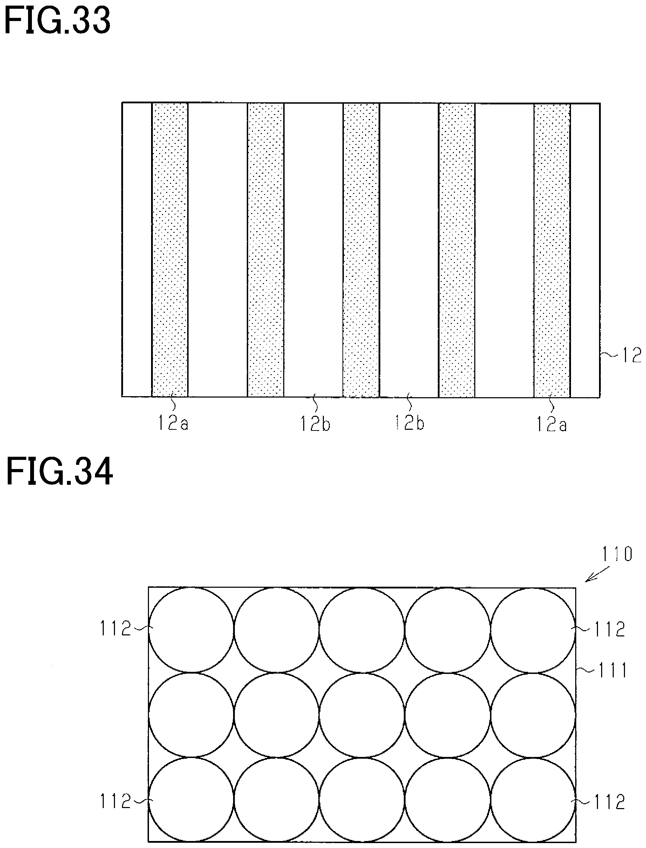

As illustrated in Fig. 32, the resin layer 12 may be irradiated with the radiation EL not via the mask M. In this case, as illustrated in Fig. 33, in the resin layer 12 after irradiation, a plurality of linear cured portions 12a aligned in the direction of alignment of the cylindrical lenses 102 are formed which are linear cured portions 12a extending in the extension direction of the cylindrical lenses 102. In the resin layer 12, in the direction of alignment of the cylindrical lenses 102, the cured portions 12a and the uncured portions 12b are alternately aligned.

In the direction of alignment of the plurality of cured portions 12a, a distance between the cured portions 12a adjacent to each other is preferably 5 µm or more. That is, in the plurality of cylindrical lenses 102, the pitch P and the aspect A described above are preferably set to have the distance between the cured portions 12a adjacent to each other of 5 µm or more. This suppresses, similar to the case of irradiating the resin layer 12 with the radiation EL using the mask M, linkage of the cured portions 12a adjacent to each other.

As illustrated in Fig. 34, a lens array layer 110 may be configured to include a support layer 111 and a plurality of microlenses 112. Each microlens 112 is, for example, a convex lens and has a circular shape in plan view facing the surface, to form the plurality of microlenses 112 in the support layer 111. The plurality of microlenses 112 are aligned in one direction and also aligned in a direction orthogonal to the one direction. In a plan view facing the plane where the support layer 111 extends, the plurality of microlenses 112 are aligned in a quadrangular grid while they may be aligned in a triangular grid or in a hexangular grid.

Each microlens 112 is in a shape having one focus on the resin layer 12. Accordingly, when the resin layer 12 is irradiated with the radiation EL via the plurality of microlenses 112, in the plan view facing the front surface 12S of the resin layer 12, the cured portions 12a are formed to be aligned in one direction and also aligned in a direction orthogonal to the one direction.

The configuration in the fourth embodiment is not limited to the configuration in the first embodiment and may be carried out in combination with each of the configuration in the second embodiment and the configuration in the third embodiment described above. That is, in the configuration of the fourth embodiment, the second substrate 80 in the second embodiment instead of the second substrate 13, and the reflective layer 83 in the second embodiment instead of the patterning target layer 14, may be applied. In the configuration of the fourth embodiment, the patterning target layer 90 in the third embodiment may be applied instead of the patterning target layer 14.

### [Reference Signs List]

11 ... First substrate
11R, 13R, 101R ... Rear surface
11S, 12S, 13S, 14S, 60S, 81S, 83S, 92S, 93S, 101S, MS ... Front surface
12 ... Resin layer
12a ... Cured portion
12b ... Uncured portion
13, 60, 80 ... Second substrate
14, 70, 90 ... Patterning target layer
14a, 71a, 72a, 83a, 91a, 92a, 93a ... First area
14b, 71b, 72b, 83b, 91b, 92b, 93b ... Second area
14P1 ... First pattern layer
14P2 ... Second pattern layer
21 ... First laminate
22 ... Second laminate
30 ... Display label
31, 51 ... Bonding layer
32 ... Release layer
41 ... Base material
51 ... Bonding layer
61, 81, 101, 111 ... Support layer
62, 71 ... Adjustment layer
72 ... Pattern formation layer
82, 91 ... Relief structure layer
82P ... Precursor Layer
82S, 91S ... Relief surface
83, 92 ... Reflective layer
93 ... Protective layer
100, 110 ... Lens array layer
102 ... Cylindrical lens
112 ... Micro lens
M ... Mask
Ma ... Transmitting area
Mb ... Blocking area.

## Claims

1. A method of producing a display body (30) comprising:
providing a patterning target layer (14) and a resin layer (12) in this order on a surface (13S) of a substrate (13) such that the layers are in contact with each other, wherein the resin layer (12) contains a resin curable by irradiation and the patterning target layer (14) contains a thermoplastic resin and a resin curable by irradiation;
irradiating the resin layer (12) which is in contact with the patterning target layer (14) with radiation to form a plurality of cured portions (12a) by partial curing of the resin layer so as to establish higher adhesion strength between the cured portions (12a) and the patterning target layer (14) than adhesion strength between the surface (13S) and the patterning target layer (14) and to establish lower adhesion strength between the uncured portion (12b) in the resin layer and the patterning target layer (14) than the adhesion strength between the surface(13S) and the patterning target layer (14), and
separating the resin layer (12) from the patterning target layer (14), thereby removing areas (14a) of the patterning target layer, which overlap the cured portions (12a) in plan view facing the surface (13S), from the substrate (13) together with the resin layer (12).

2. The method of producing a display body according to claim 1, further comprising:
forming, prior to the forming of the cured portions (12a), a lens array layer (100) including a plurality of lenses (102) to focus radiation on the resin layer (12); and
stacking, prior to the forming of the cured portions (12a), the lens array layer (100) and the resin layer (12), wherein
the irradiating the resin layer (100) with radiation includes irradiating the plurality of lenses (102) with radiation from an opposite side to a side facing the resin layer, onto the resin layer.

3. The method of producing a display body according to claim 1 or 2, wherein the forming of the patterning target layer (90) includes forming a reflective layer (92).

4. The method of producing a display body (30) according to claim 3, wherein
the forming of the patterning target layer (90) includes:
forming a relief structure layer (91) on the front surface of the second substrate (13) so that a surface of the relief structure layer (91) facing away from the substrate (13) is formed as a relief surface (92S) which is configured to emit diffracted light by a cycle of projections and recesses; and
forming the reflective layer (92) to cover the relief surface (92S).

5. The method of producing a display body according to any one of claims 1 to 4, wherein,
an area of the patterning target layer (14) separated together with the resin layer (12) from the second substrate (13) is a first area (14a), and an area other than the first area is a second area (14b),
a first laminate (21) containing the resin layer (12) and the first area (14a) and a second laminate (22) containing the second substrate (13) and the second area (14b) are formed when the resin layer (12) is separated from the patterning target layer (14), and
the display body (30) is produced from either one of the first laminate (21) and the second laminate (22).

## Patentansprüche

1. Verfahren zur Herstellung eines Anzeigekörpers (Displaykörpers) (30), das die folgenden Schritte umfasst:
Bereitstellen einer Strukturierungszielschicht (14) und einer Harzschicht (12) in dieser Reihenfolge auf einer Oberfläche (13S) eines Substrats (13) derart, dass die Schichten in Kontakt miteinander stehen, wobei die Harzschicht (12) ein durch Bestrahlung härtbares Harz enthält und die Strukturierungszielschicht (14) ein thermoplastisches Harz und ein durch Bestrahlung härtbares Harz enthält;
Bestrahlen der Harzschicht (12), die in Kontakt mit der Strukturierungszielschicht (14) steht, mit Strahlung, um mehrere gehärtete Teile (12a) durch teilweises Härten der Harzschicht auszubilden, um eine höhere Haftfestigkeit zwischen den gehärteten Teilen (12a) und der Strukturierungszielschicht (14) als die Haftfestigkeit zwischen der Oberfläche (13S) und der Strukturierungszielschicht (14) zu etablieren und eine niedrigere Haftfestigkeit zwischen dem ungehärteten Teil (12b) in der Harzschicht und der Strukturierungszielschicht (14) als die Haftfestigkeit zwischen der Oberfläche (13S) und der Strukturierungszielschicht (14) zu etablieren und
Trennen der Harzschicht (12) von der Strukturierungszielschicht (14), um hierdurch Bereiche (14a) der Strukturierungszielschicht, die in Draufsicht, der Oberfläche (13S) zugewandt, mit den gehärteten Teilen (12a) überlappen, zusammen mit der Harzschicht (12) von dem Substrat (13) zu entfernen.

2. Verfahren zur Herstellung eines Anzeigekörpers gemäß Anspruch 1, das weiter die folgenden Schritte umfasst:
Ausbilden einer Linsenarray-Schicht (100), die mehrere Linsen (102) einschließt, um Strahlung auf die Harzschicht (12) zu fokussieren, vor der Ausbildung der gehärteten Teile (12a); und
Schichten der Linsenarray-Schicht (100) und der Harzschicht (12) vor der Ausbildung der gehärteten Teile (12a), wobei
das Bestrahlen der Harzschicht (100) mit Strahlung das Bestrahlen der mehreren Linsen (102) mit Strahlung von einer entgegengesetzten Seite zu einer Seite, die der Harzschicht gegenüberliegt, auf die Harzschicht, einschließt.

3. Verfahren zur Herstellung eines Anzeigekörpers gemäß Anspruch 1 oder 2, bei dem das Ausbilden der Strukturierungszielschicht (90) das Ausbilden einer Reflexionsschicht (92) einschließt.

4. Verfahren zur Herstellung eines Anzeigekörpers (30) gemäß Anspruch 3, bei dem das Ausbilden der Strukturierungszielschicht (90) die folgenden Schritte einschließt:
Ausbilden einer Reliefstrukturschicht (91) auf der Vorderseite des zweiten Substrats (13), so dass eine Oberfläche der Reliefstrukturschicht (91), die von dem Substrat (13) abgewandt ist, als eine Reliefoberfläche (92S) ausgebildet wird, die eingerichtet ist, durch einen Zyklus von Vorsprüngen und Rücksprüngen gebeugtes Licht zu emittieren; und
Ausbilden der Reflexionsschicht (92), so dass sie die Reliefoberfläche (92S) bedeckt.

5. Verfahren zur Herstellung eines Anzeigekörpers gemäß mindestens einem der Ansprüche 1 bis 4, bei dem
ein Bereich der Strukturierungszielschicht (14), der zusammen mit der Harzschicht (12) von dem zweiten Substrat (13) getrennt wird, ein erster Bereich (14a) ist und ein anderer Bereich als der erste Bereich ein zweiter Bereich (14b) ist,
ein erstes Laminat (21), das die Harzschicht (12) und den ersten Bereich (14a) enthält, und ein zweites Laminat (22), das das zweite Substrat (13) und den zweiten Bereich (14b) enthält, gebildet werden, wenn die Harzschicht (12) von der Strukturierungszielschicht (14) getrennt wird und
der Anzeigekörper (30) aus dem ersten Laminat (21) oder dem zweiten Laminat (22) hergestellt wird.

## Revendications

1. Procédé de production d'un corps d'affichage (30) comprenant les étapes consistant à :
fournir une couche cible de configuration (14) et une couche de résine (12) dans cet ordre sur une surface (13S) d'un substrat (13) de telle sorte que les couches sont en contact l'une avec l'autre, dans lequel la couche de résine (12) contient une résine durcissable par irradiation et la couche cible de configuration (14) contient une résine thermoplastique et une résine durcissable par irradiation ;
irradier la couche de résine (12) qui est en contact avec la couche cible de configuration (14) à l'aide d'un rayonnement pour former une pluralité de parties durcies (12a) par durcissement partiel de la couche de résine de manière à établir une force d'adhérence plus élevée entre les parties durcies (12a) et la couche cible de configuration (14) qu'une force d'adhérence entre la surface (13S) et la couche cible de configuration (14) et pour établir une force d'adhérence plus faible entre la partie non durcie (12b) dans la couche de résine et la couche cible de configuration (14) que la force d'adhérence entre la surface (13S) et la couche cible de configuration (14), et
séparer la couche de résine (12) de la couche cible de configuration (14), en retirant ainsi des zones (14a) de la couche cible de configuration, qui chevauchent les parties durcies (12a) sur une vue en plan faisant face à la surface (13S), depuis le substrat (13) ensemble avec la couche de résine (12).

2. Procédé de production d'un corps d'affichage selon la revendication 1, comprenant en outre :
la formation, avant la formation des parties durcies (12a), d'une couche de réseau de lentilles (100) incluant une pluralité de lentilles (102) pour focaliser un rayonnement sur la couche de résine (12) ; et
l'empilement, avant la formation des parties durcies (12a), de la couche de réseau de lentilles (100) et de la couche de résine (12), dans lequel
l'irradiation de la couche de résine (100) à l'aide d'un rayonnement inclut l'irradiation de la pluralité de lentilles (102) à l'aide d'un rayonnement depuis un côté opposé à un côté faisant face à la couche de résine, sur la couche de résine.

3. Procédé de production d'un corps d'affichage selon la revendication 1 ou 2, dans lequel la formation de la couche cible de configuration (90) inclut la formation d'une couche réfléchissante (92).

4. Procédé de production d'un corps d'affichage (30) selon la revendication 3, dans lequel
la formation de la couche cible de configuration (90) inclut :
la formation d'une couche de structure en relief (91) sur la surface avant du second substrat (13) de sorte qu'une surface de la couche de structure en relief (91) faisant face à l'opposé du substrat (13) est formée comme une surface en relief (92S) qui est configurée pour émettre une lumière diffractée par un cycle de saillies et de creux ; et
la formation de la couche réfléchissante (92) pour recouvrir la surface en relief (92S).

5. Procédé de production d'un corps d'affichage selon l'une quelconque des revendications 1 à 4, dans lequel,
une zone de la couche cible de configuration (14) séparée ensemble avec la couche de résine (12) depuis le second substrat (13) est une première zone (14a), et une zone autre que la première zone est une seconde zone (14b),
un premier stratifié (21) contenant la couche de résine (12) et la première zone (14a) et un second stratifié (22) contenant le second substrat (13) et la seconde zone (14b) sont formés lorsque la couche de résine (12) est séparée de la couche cible de configuration (14), et
le corps d'affichage (30) est produit à partir de l'un parmi le premier stratifié (21) et le second stratifié (22).
